# EUROPÄISCHE PATENTSCHRIFT

(11) **EP 3 884 527 B1**
(45) Veröffentlichungstag und Bekanntmachung des Hinweises auf die Patenterteilung: **24.07.2024**
(21) Anmeldenummer: 19823998.0
(22) Anmeldetag: 21.11.2019
(51) Int. Cl.: F04B 43/04, H10N 35/01, H10N 35/80

(54) **TRANSPORTVORRICHTUNG MIT AKTOR UND TRENNSCHICHT**
TRANSPORT DEVICE HAVING AN ACTUATOR AND SEPARATING LAYER
DISPOSITIF DE TRANSPORT COMPRENANT UN ACTIONNEUR ET UNE COUCHE DE SÉPARATION

(30) Priorität: 23.11.2018 DE 102018129634
(43) Veröffentlichungstag der Anmeldung: 29.09.2021
(73) Patentinhaber: HNP Mikrosysteme GmbH, 19053 Schwerin (DE)
(72) Erfinder: POLLEY, Tim, 19055 Schwerin (DE); WEISENER, Thomas, 19061 Schwerin (DE); VOEGELE, Gerald, 71065 Sindelfingen (DE); REIMANN, Sven, 19288 Ludwigslust (DE)
(74) Vertreter: Ter Meer Steinmeister & Partner
(86) Internationale Anmeldenummer: PCT/IB2019/060042
(87) Internationale Veröffentlichungsnummer: WO 2020/104996

(56) Entgegenhaltungen:
- WO-A1-2008/150210
- JP-A- 2002 228 033
- US-A1- 2009 112 155
- SAREN A ET AL: "Integratable magnetic shape memory micropump for high-pressure, precision microfluidic applications", MICROFLUIDICS AND NANOFLUIDICS, SPRINGER, DE, vol. 22, no. 4, 16 March 2018 (2018-03-16), pages 1 - 10, XP036485757, ISSN: 1613-4982, [retrieved on 20180316], DOI: 10.1007/S10404-018-2058-0

## Beschreibung

Die Erfindung betrifft eine Transportvorrichtung, die einen Aktor mit einer Formgedächtnislegierung umfasst, wobei der Aktor eine Trennschicht aufweist.

Formgedächtnislegierungen (engl. shape memory alloy) können in unterschiedlichen Kristallstrukturen vorliegen, wobei die Form des Materials abhängig von der Kristallstruktur ist, in der die Legierung vorliegt.

Spezielle Formgedächtnislegierungen sind magnetische Formgedächtnislegierungen (engl. magnetic shape memory alloy, MSMA), deren Form durch Anlegen eines Magnetfelds verändert werden kann. Dabei sind Zwillingsgrenzen in magnetischen Formgedächtnislegierungen durch ein Magnetfeld beweglich, wodurch es zu einer magnetisch induzierten Reorientierung des Materials kommt. Durch ein senkrechtes Magnetfeld lässt sich das Material strecken und durch ein paralleles Magnetfeld lässt sich das Material kontrahieren.

Das Grundprinzip einer magnetfeldinduzierten Formänderung eines Aktors aus einem Material mit Zwillingsgrenze ist in US 6,515,382 B1 offenbart.

Der Einsatz einer magnetischen Formgedächtnislegierung als Aktor in einer Pumpe ist bekannt aus US 2016/0211065 A1. Darin ist ein Aktor aus einer MSMA beschrieben, der in einem Gehäuse mit einem Einlass und einem Auslass angeordnet ist. Unterhalb des Aktors sind mehrere Spulen, durch die ein Magnetfeld erzeugt werden kann, angeordnet. Durch Erzeugen eines Magnetfelds kann die Form der MSMA so verändert werden, dass sich eine Kavität bildet, die mit dem Einlass kommunizierend verbunden ist. Ein Fluid strömt in die Kavität und durch eine Bewegung des Magnetfelds bewegt sich die mit dem Fluid gefüllte Kavität. Ist die gefüllte Kavität kommunizierend mit dem Auslass verbunden, strömt das Fluid in der Kavität aus dem Auslass aus.

Bekannte Pumpen mit einem Aktor, der eine magnetische Formgedächtnislegierung umfasst, sind nicht für alle zu fördernden Medien geeignet. Speziell mangelt es solchen bekannten Pumpen an einer Biokompatibilität.

Saren A et al., "Integratable magnetic shape memory micropump for high-pressure, precision microfluidic applications", MICROFLUIDICS AND NANOFLUIDICS, SPRINGER, DE, vol. 22, no. 4, doi:10.1007/S10404-018-2058-0 betrifft eine integrierbare Mikropumpe mit magnetischer Formgedächtnislegierung.

JP 2002-228033 A betrifft ein Mikroventil umfassend ein Durchflusskanalteil mit einem Kanal für ein Fluid und ein Betätigungsteil zur Steuerung eines Fluidstroms, wobei das Durchflusskanalteil und das Betätigungsteil trennbar aufgebaut sind. Der Kanalteil ist wegwerfbar und der Betätigungsteil ist wiederverwendbar.

US 2009 / 0112155 A1 betrifft Mikropumpen, die für die Infusion von Insulin bei einem Diabetiker nützlich sein kann. Die Pumpe verwendet eine Pumpenkammer mit einer Membran und einer Vielzahl von Rückschlagventilen, die so konfiguriert sind, dass sie ein Auslaufen aus dem Reservoir durch den Pumpenmotor und in eine Infusionsvorrichtung verhindern und außerdem die vollständige, genaue Entleerung der Pumpenkammer sicherstellen.

WO 2008 / 150210 A1 betrifft eine Verdrängungsmikropumpe. Die Verdrängungsmikropumpe umfasst eine Pumpkammer, ein Einlassventil, ein Auslassventil und eine erste flexible Membran, die so angeordnet ist, dass sie das Volumen der Pumpkammer verändern kann, sowie integrierte Mittel zur Bewegung der flexiblen Membran. Die Mikropumpe ist eine Mehrschichtstruktur mit einer Vielzahl von Schichten, wobei mindestens eine Schicht eine mikrostrukturierte Schicht aus einem Metall oder einer Metallegierung wie Edelstahl ist. Die Mehrzahl der Schichten umfasst eine mikrostrukturierte mikrofluidische Schicht, die zumindest teilweise die Pumpkammer bildet.

Eine **Aufgabe** der Erfindung liegt darin, eine Transportvorrichtung bereitzustellen, durch die ein breites Spektrum von Fluiden, auch sensible Fluide, gefördert oder transportiert werden kann. Auch soll ein vergrößerter Fluidvolumenstrom gefördert oder transportiert werden können. Eine weitere Aufgabe liegt in der Bereitstellung einer Transportvorrichtung mit einer Dichtstruktur, durch die eine Verbesserung des Druckaufbaus ermöglicht wird. Eine weitere Aufgabe liegt darin, eine Transportvorrichtung mit einer Dichtstruktur bereitzustellen, durch die eine Leckage während des Transports eines Fluids reduziert wird. Eine noch weitere Aufgabe liegt darin, eine Transportvorrichtung bereitzustellen, die sich prozesssicher und gleichzeitig kostengünstig fertigen lässt. Der Betrieb der Transportvorrichtung soll verbessert überwachbar sein oder der Betrieb verbessert regelbar sein.

**Gelöst wird die Aufgabe** durch eine Transportvorrichtung nach Anspruch 1. Vorteilhafte Ausgestaltungen sind in den abhängigen Ansprüchen angegeben.

Eine Tranportvorrichtung zum Transport eines Fluids umfasst ein Gehäuse, einen Aktor und einen Antrieb. Das Gehäuse umfasst einen Fluideinlass und einen Fluidauslass. Der Aktor umfasst eine magnetische Formgedächtnislegierung (MSMA), der zumindest abschnittsweise in dem Gehäuse angeordnet ist. Der Antrieb kann den Aktor so verformen, dass in dem Aktor eine Kavität für das Fluid gebildet wird, die von dem Aktor bewegbar ist, um das Fluid in der Kavität von dem Fluideinlass zu dem Fluidauslass zu transportieren. Zumindest ein Abschnitt des Aktors weist eine Trennschicht auf. Durch die Trennschicht ist an dem mit der Trennschicht versehenen Abschnitt des Aktors ein direkter Kontakt zwischen dem Fluid und dem Aktor verhindert.

Der direkte Kontakt bezieht sich auf einen Kontakt zwischen dem Aktor und dem Fluid ohne Trennschicht.

Speziell kann die Transportvorrichtung eine Strömungsmaschinenvorrichtung sein. Die Strömungsmaschinenvorrichtung kann sowohl inkompressible als auch kompressible Medien transportieren oder fördern. Inkompressible Medien sind solche Medien, die im Wesentlichen inkompressible sind oder kaum kompressible sind. Ein inkompressibles Medium ist zumindest um ein Vielfaches weniger kompressible als ein Gas.

Die Transportvorrichtung kann eine Pumpvorrichtung zum Transport einer Flüssigkeit sein. Speziell handelt es sich bei der Transportvorrichtung um eine Mikropumpenvorrichtung. Eine Mikropumpenvorrichtung kann eine maximale Förderleistung von maximal 10 ml pro Minute ausweisen, speziell maximal 1 ml pro Minute aufweisen.

Die magnetische Formgedächtnislegierung kann eine Nickel-Mangan-Gallium-Legierung sein.

Bevorzugt besteht der Aktor aus einer magnetischen Formgedächtnislegierung.

Der Aktor kann ein Pumpaktor sein.

Der Aktor kann vollständig in dem Gehäuse angeordnet sein, sodass dieser vollständig von dem Gehäuse umgeben ist, oder, wenn eine oder mehrere Seiten des Gehäuses geöffnet sind, kann der Aktor nicht über die eine oder mehrere Seiten des Gehäuses hinausragen.

Der Aktor kann zwei Stirnflächen, zwei Seitenflächen und zwei Kavitätsflächen aufweisen. In jeder der zwei Kavitätsflächen kann zumindest eine Kavität ausgebildet werden.

Eine Kavität kann ein (abgeschlossener) Hohlraum oder eine Aushöhlung (Einschnürung oder Einbuchtung) sein, die eine oder mehrere Öffnungen aufweist.

Der Aktor kann im Wesentlichen quaderförmig ausgestaltet sein.

Die Kavitätsflächen besitzen eine deutlich größere Fläche als die Seitenflächen oder die Stirnflächen, bevorzugt sind die Flächen der Kavitätsflächen um ein Vielfaches größer als die Flächen der Seitenflächen oder der Stirnflächen. Durch die Bildung der Kavitäten in dem Aktor erfolgt eine Ausdehnung des Aktors speziell in Richtung der Stirnflächen (Volumenstabilität).

Durch den Antrieb ist ein homogen gerichtetes magnetisches Wanderfeld erzeugbar. Hierfür umfasst der Antrieb insbesondere elektromagnetische Spulen und/oder Permanentmagneten. Speziell können durch den Antrieb mehrere magnetische Wanderfelder gleichzeitig auf derselben Kavitätsfläche erzeugt und bewegt werden.

Die Trennschicht kann sich über eine gesamte Seite des Aktors erstrecken. Speziell erstreckt sich die Trennschicht über eine gesamte Kavitätsfläche des Aktors.

Der Aktor kann eine Gesamtoberfläche aufweisen und die Trennschicht kann sich über zumindest 80% oder 90% der Gesamtoberfläche des Aktors erstrecken.

Insbesondere erstreckt sich die Trennschicht über die gesamte Oberfläche des Aktors.

Die Dicke der Trennschicht kann kleiner sein als die maximale Tiefe der Kavität. Speziell kann es sich bei der Dicke der Trennschicht um einen Mittelwert der Dicke der Trennschicht handeln. Bei der maximalen Tiefe der Kavität kann es sich um die maximal ausbildbare Tiefe einer Kavität in einer der Kavitätsflächen handeln.

Die Trennschicht kann eine Folie ein. Speziell ist die Folie eine Kunststofffolie, die z. B. Polyethylen oder Polypropylen umfasst.

Zwischen der Folie und dem Aktor kann ein Unterdruck gegenüber der Umgebung der Folie herrschen. Dadurch bestehen eine enge und eine einer Formveränderung des Aktors folgende Verbindung zwischen der Folie und dem Aktor.

Die Folie kann ein Ventil umfassen. Speziell kann über das Ventil der Druck zwischen der Folie und dem Aktor verändert werden.

Die Folie kann eine Verschweißung aufweisen. Um die Trennschicht auf den Aktor aufzubringen können beispielsweise zwei Folienelemente um den Aktor gelegt werden und die Folienelemente so miteinander verschweißt werden, dass die Folie luftdicht um den Aktor gelegen ist.

Zwischen der Folie und dem Aktor kann eine Flüssigkeit vorliegen. Speziell kann als Flüssigkeit Silikonöl verwendet werden. Die Flüssigkeit kann eine Adhäsionskraft zwischen der Folie und dem Aktor aufbringen und eine entstehende Reibung (bei Verformung des Aktors) zwischen der Folie und dem Aktor reduzieren.

Die Trennschicht kann eine Beschichtung sein. Insbesondere ist die Beschichtung festhaftend mit dem Aktor verbunden.

Die Beschichtung kann ein Parylen umfassen.

Bei dem Parylen kann es sich um ein vollständig mit Wasserstoff substituiertes Parylen handeln (Parylen N). Bei dem Parylen kann es sich auch um ein mit Halogen-substituiertes Parylen handeln. Insbesondere ist das Parylen ein teilweise mit Chlor substituiertes Parylen (Parylen C oder Parylen D). Ebenso kann das Parylen ein teilweise mit Fluor substituiertes Parylen sein (Parylen HT).

Die Beschichtung kann durch eine chemische Gasphasenabscheidung (CVD), eine physikalische Gasphasenabscheidung (PVD), durch Kathodenzerstäubung oder Resublimation auf den Aktor aufgebracht werden. Speziell wird die Beschichtung durch Resublimation auf den Aktor aufgebracht.

Zwischen dem Aktor und der Trennschicht kann ein Haftvermittler vorgesehen sein. Der Haftvermittler kann zwischen den physikalischen und/oder chemischen Eigenschaften der Aktoroberfläche und der Trennschicht vermitteln.

Die Vorrichtung (Transportvorrichtung) kann ein Dichtelement umfassen. Das Dichtelement kann so ausgestaltet sein und zwischen dem Aktor und dem Gehäuse angeordnet sein, dass die Kavität während des Transports des Fluids von dem Fluideinlass zu dem Fluidauslass randseitig oder endseitig abgedichtet ist.

Zumindest ein Abschnitt des Dichtelements kann eine elastische Eigenschaft aufweisen. Dieser Abschnitt des Dichtelements kann an einem randseitigen oder endseitigen Abschnitt der Kavität des Aktors dichtend anliegen, wenn eine Kavität in dem Aktor gebildet ist.

Dadurch kann der Abschnitt des Dichtelements an dem Aktor anliegen, wenn keine Kavität gebildet ist und durch die elastische Eigenschaft des Abschnitts des Dichtelements kann das Dichtelement an der Kavität des Aktors anliegen, wenn eine solche Kavität in dem Aktor gebildet ist.

Die elastische Eigenschaft kann eine linear-elastische-Eigenschaft sein oder eine nichtlinear-elastische Eigenschaft sein.

Unter Krafteinwirkung soll das Dichtelement komprimierbar sein und nach Aufhebung der Krafteinwirkung soll das Dichtelement seine Ursprungsform wieder zumindest teilweise annehmen. Speziell soll das Dichtelement bei einer Kompression durch eine Kraft eine der Kompression entgegenwirkende Kraft ausüben. Dies verbessert die Dichtfunktion.

Das Gehäuse kann eine Nut aufweisen, wobei zumindest ein Abschnitt des Dichtelements in der Nut angeordnet sein kann.

Die Öffnung der Nut kann in Richtung des Aktors weisen.

Die Nut des Gehäuses kann so ausgestaltet sein, dass die Nut einen Flächenabschnitt des Gehäuses umläuft oder einschließt. Speziell ist die Nut durchgängig und umläuft den Flächenabschnitt des Gehäuses vollständig oder schließt den Flächenabschnitt des Gehäuses vollständig ein.

Das Dichtelement in der Nut kann den Flächenabschnitt des Gehäuses ebenso umlaufen oder einschließen, insbesondere kann das Dichtelement den Flächenabschnitt des Gehäuses durchgängig (vollständig) umlaufen oder einschließen.

Der Flächenabschnitt des Gehäuses, der von der Nut oder dem Dichtelement umlaufen oder eingeschlossen wird, kann den Fluideinlass und/oder den Fluidauslass umfassen.

In Verbindung mit dem Dichtelement in der Nut ergibt sich auf dem Aktor ein Bereich, der dem von der Nut eingeschlossenen Flächenabschnitt des Gehäuses (im Wesentlichen) entspricht, in dem ein Fluid von dem Fluideinlass zu dem Fluidauslass (in der Kavität) transportiert werden kann, wobei dieser nach außen abgedichtet ist, auch wenn eine Kavität vorhanden ist.

Der Aktor kann von dem Antrieb so verformbar sein, dass in dem Aktor zwei von dem Antrieb bewegbare Kavitäten für das Fluid gebildet werden. In den Kavitäten kann das Fluid von dem Fluideinlass zu dem Fluidauslass transportiert werden.

Die Vorrichtung kann ein Dichtelement umfassen, das zumindest eine Ausnehmung aufweist. Das Dichtelement kann so in dem Gehäuse angeordnet sein, dass die Kavitäten zumindest zeitweise (über einen begrenzten Zeitraum) während des Transports des Fluids von dem Fluideinlass zu dem Fluidauslass über die Ausnehmung fluidkommunizierend verbunden sind.

Durch die Ausnutzung von zwei Kavitäten in dem Aktor zum Transportieren des Fluids kann der transportierbare Volumenstrom durch die Transportvorrichtung erhöht werden.

Typischerweise werden zwei Kavitäten in dem Aktor auf sich gegenüberliegenden Seiten des Aktors gebildet. Im Bereich der Ausnehmung in dem Dichtelement sind die gebildeten Kavitäten fluidkommunizierend. Ist eine der miteinander fluidkommunizierend verbundenen Kavitäten wiederum fluidkommunizierend mit dem Fluideinlass verbunden, kann das Fluid durch den Fluideinlass in beide Kavitäten einströmen. Durch ein Bewegen des Magnetfeldes des Antriebs können die Kavitäten in Richtung des Fluidauslasses bewegt werden. Erreichen die Kavitäten den Fluidauslass so, dass eine der Kavitäten mit dem Fluidauslass fluidkommunizierend verbunden ist und die Kavitäten miteinander fluidkommunizierend verbunden sind, kann das transportierte Fluid aus beiden Kavitäten über den Fluidauslass aus der Transportvorrichtung ausströmen.

Der Aktor kann so verformbar sein, dass sich die Kavitäten auf gegenüberliegenden Seiten des Aktors bilden.

Das Dichtelement kann zumindest zwei Ausnehmungen umfassen. Insbesondere können die zwei Ausnehmungen so in dem Dichtelement ausgebildet sein, dass keine Fluidkommunikation zwischen den Ausnehmungen möglich ist, wenn das Fluid von dem Fluideinlass zu dem Fluidauslass transportiert wird.

Insbesondere kann eine der zwei Ausnehmungen im Bereich des Fluideinlasses ausgebildet sein und die andere der zwei Ausnehmungen im Bereich des Fluidauslasses ausgebildet sein.

Speziell kann ein Abstand zwischen dem Fluideinlass oder einem Diffusor und einer der Ausnehmungen kleiner als 100 mm, insbesondere kleiner als 50 mm, speziell kleiner als 20 mm, sein und/oder ein Abstand zwischen dem Fluidauslass oder einem Diffusor und einer der Ausnehmungen kleiner als 100 mm, insbesondere kleiner als 50 mm, speziell kleiner als 20 mm, sein.

Das Dichtelement kann vier Ausnehmungen umfassen, speziell können zwei der Ausnehmungen so ausgebildet sein, dass während des Transports des Fluids von dem Fluideinlass zu dem Fluidauslass die zwei Ausnehmungen zumindest zeitweise fluidkommunizierend verbunden sind (von einer Kavitäten oder von beiden Kavitäten).

Die anderen zwei der Ausnehmungen können ebenso ausgestaltet sein, zumindest zeitweise während des Transports des Fluids von dem Fluideinlass zu dem Fluidauslass fluidkommunizierend verbunden zu sein. Dies ebenso von einer oder von beiden Kavitäten.

Das Dichtelement kann zumindest zwei Flächen unterschiedlicher Seiten des Aktors zumindest abschnittsweise kontaktieren. Speziell kann das Dichtelement zumindest abschnittsweise die Seitenflächen des Aktors kontaktieren.

Das Gehäuse kann eine obere Seite aufweisen, wobei die obere Seite im Wesentlichen parallel zu der Seite des Aktors ist, in der ein Großteil (mindestens 50%) einer der Kavitäten gebildet werden soll. Der Fluideinlass und/oder der Fluidauslass können sich aus der oberen Seite des Gehäuses erstrecken. Der Fluideinlass und/oder der Fluidauslass können sich auch aus einer Seite des Gehäuses erstrecken, die seitlich zu der oberen Seite des Gehäuses ist.

Die Transportvorrichtung kann eine erste Dichtbahn und eine zweite Dichtbahn umfassen. Die erste Dichtbahn kann eine Seite des Aktors kontaktieren und die zweite Dichtbahn kann eine andere Seite des Aktors kontaktieren.

Bevorzugt kontaktieren die erste Dichtbahn und die zweite Dichtbahn gegenüberliegende Seiten des Aktors.

Die Transportvorrichtung kann ein Einspannelement umfassen, das eine trapezförmige Grundform aufweist und an einer Seite des Aktors anliegt. Das Einspannelement kann im Wesentlichen inkompressible sein.

Das Einspannelement kann das Gehäuse und/oder das Dichtelement kontaktieren.

In dem Gehäuse kann eine Gegenstruktur vorgesehen sein, die ausgebildet ist, das trapezförmige Einspannelement zumindest abschnittsweise aufzunehmen. Die Transportvorrichtung kann auch zwei Einspannelemente mit je trapezförmiger Grundform umfassen. Eines der Einspannelemente kann an einer Seite des Aktors anliegen und das andere der Einspannelemente kann an einer anderen Seite des Aktors anliegen.

Insbesondere kann eines der Einspannelemente an einer Seite des Aktors anliegen und das andere der Einspannelemente an einer gegenüberliegenden Seite des Aktors anliegen.

Das oder die Einspannelemente können sich über die gesamte Länge der jeweils kontaktierten Seite des Aktors erstrecken.

Die Transportvorrichtung kann zumindest ein Einspannelement umfassen, das eine Seitenfläche, insbesondere eine Stirnfläche, des Aktors kontaktiert und durch das eine mechanische Rückstellung des Aktors gewährleistet wird. Bevorzugt umfasst die Transportvorrichtung zwei Einspannelemente, die gegenüberliegende Seitenflächen, insbesondere Stirnflächen, des Aktors kontaktieren und eine mechanische Rückstellung des Aktors möglich machen.

Wird eine Kavität in dem Aktor gebildet (durch den Antrieb), dehnt sich der Aktor in eine oder mehrere Richtungen aus, wobei dies typischerweise in Richtung der Stirnflächen des Aktors geschieht. Wird beispielsweise ein Magnetfeld des Antriebs beendet, erfolgt keine veranlassungslose Rückstellung der Kavität, sondern diese kann durch eine mechanische Krafteinwirkung der Einspannelemente erfolgen.

Zumindest ein Einspannelement, bevorzugt zwei Einspannelemente, kann eine trapezförmige Grundform aufweisen.

Die Vorrichtung, insbesondere das Gehäuse oder das Dichtelement oder das/die Einspannelement/e, kann auch zumindest einen, bevorzugt zumindest zwei Magneten umfassen, durch die eine magnetische Rückstellung des Aktors möglich ist. Speziell kann der oder die Magnete ein oder mehrere Permanentmagnete oder Elektromagnete sein.

Die magnetische Rückstellung des Aktors funktioniert analog zur mechanischen Rückstellung des Aktors, wie oben beschrieben.

Die Vorrichtung, insbesondere das Gehäuse oder das Dichtelement oder das/die Einspannelement/e, kann auch ein magnetorheologisches Elastomer umfassen.

Das Gehäuse kann zumindest einen Diffusor umfassen. Speziell umfasst das Gehäuse zwei Diffusoren.

Da eine Kavität in der Regel über die gesamte Breite des Aktors erzeugt wird, erlaubt ein Diffusor am Fluideinlass und/oder ein Diffusor am Fluidauslass eine verbesserte Fluidführung von dem Fluideinlass in die Kavität und/oder von der Kavität zu dem Fluidauslass.

Ein Diffusor kann mit dem Fluideinlass verbunden sein und ein weiterer Diffusor kann mit dem Fluidauslass verbunden sein. Dabei kann die Querschnittsfläche des Diffusors an dem Ende des Diffusors, der dem Aktor näherliegender ist, größer sein, als die Querschnittsfläche des Endes des Diffusors, das dem Aktor entfernter ist. Dies kann für alle Diffusoren gelten.

Das Dichtelement kann ein Elastomer umfassen. Insbesondere kann das Elastomer ein thermoplastisches Elastomer sein. Das Dichtelement kann auch alternativ oder zusätzlich einen Schaumstoff umfassen. Der Schaumstoff ist speziell ein geschlossenzelliger Schaumstoff.

Das Gehäuse kann ein Metall oder einen Kunststoff umfassen, bevorzugt besteht das Gehäuse aus Metall oder aus Kunststoff. Bevorzugt ist das Gehäuse aus einem Elastomer gefertigt (thermoplastisches Elastomer) oder umfasst ein Elastomer (thermoplastisches Elastomer). Alternativ oder zusätzlich kann das Gehäuse ein Gradienten-Material umfassen oder aus einem Gradienten-Material bestehen.

Das Gehäuse der Transportvorrichtung kann zumindest abschnittsweise eine PTFE-Beschichtung aufweisen (Polytetrafluorethylen-Beschichtung). Bevorzugt ist zumindest die Fläche des Gehäuses mit PTFE beschichtet, die eine Begrenzungsfläche der Kavität ist.

In dem Aktor der Transportvorrichtung können zumindest zwei, insbesondere mehrere, Kavitäten gleichzeitig in dem Aktor bildbar sein. Dies beispielsweise durch eine passende Ausgestaltung des Antriebs. Die zumindest zwei Kavitäten können auf derselben Seite des Aktors bildbar und bewegbar sein.

Die Transportvorrichtung kann zumindest einen Sensor umfassen. Bevorzugt ist der Sensor an dem Gehäuse befestigt.

Die Transportvorrichtung kann einen Temperatursensor umfassen, der die Temperatur des Aktors misst. Eine Steuereinheit kann den Betrieb der Transportvorrichtung verändern, und zwar auf Grundlage des vom Temperatursensor erfassten Wertes. Insbesondere kann die Steuereinheit den Betrieb der Transportvorrichtung verändern, wenn der von dem Temperatursensor erfasste Temperaturwert des Aktors einen festgelegten Schwellenwert der Temperatur überschreitet und/oder unterschreitet.

Die Transportvorrichtung kann einen optischen Sensor umfassen, durch den erfassbar ist, ob eine Kavität in dem Aktor vorhanden ist. Der optische Sensor kann so ausgestaltet sein, dass die Frequenz von Kavitäten in dem Aktor in einem Bereich des Aktors erfasst wird. Auf Grundlage des von dem optischen Sensor gemessenen Wertes kann eine Steuereinheit der Vorrichtung den Betrieb der Transportvorrichtung verändern. Insbesondere kann der Volumenstrom durch die Transportvorrichtung des Fluids mit dem optischen Sensor erfasst werden und die Transportvorrichtung auf Grundlage des erfassten Werts geregelt werden.

Die Transportvorrichtung kann einen Drucksensor umfassen, der den Druck am Fluideinlass oder am Fluidauslass erfasst. Die Transportvorrichtung kann auch zwei Drucksensoren umfassen, wobei je ein Drucksensor den Druck am Fluideinlass und am Fluidauslass erfasst. Auf Grundlage des erfassten Wertes durch zumindest einen der Drucksensoren kann der Betrieb der Transportvorrichtung (z. B. durch eine Steuereinheit) verändert werden.

Die Transportvorrichtung kann auch einen Differenzdrucksensor umfassen, der eine Druckdifferenz zwischen dem Fluideinlass und dem Fluidauslass erfasst oder misst. Dabei kann der Differenzdrucksensor zwei Drucksensoren vor dem Fluideingang oder zwei Drucksensoren nach dem Fluidausgang umfassen.

Beispielsweise durch eine Steuereinheit kann der Betrieb der Transportvorrichtung auf Grundlage des Wertes, der von dem Differenzdrucksensor erfasst wurde, verändert werden.

Die Vorrichtung kann zumindest einen Piezosensor umfassen, wobei durch den zumindest einen Piezosensor die Aktuierung des Aktors erfasst oder gemessen werden kann. Auf Grundlage des erfassten oder gemessenen Wertes durch den zumindest einen Piezosensor kann der Betrieb der Transportvorrichtung verändert werden, beispielsweise durch eine Steuereinheit. Die Transportvorrichtung kann auch zwei Piezosensoren umfassen, die bevorzugt auf gegenüberliegenden Seiten des Aktors angeordnet sind.

Die Transportvorrichtung kann einen, bevorzugt zwei, Dehnmessstreifen umfassen. Durch den zumindest einen Dehnmessstreifen kann die Aktuierung des Aktors erfasst oder gemessen werden. Insbesondere kann der erfasste oder gemessene Wert durch den Dehnmessstreifen oder die Dehnmessstreifen verwendet werden, um den Betrieb der Transportvorrichtung zu verändern.

Durch ein Verfahren kann ein Aktor hergestellt werden, der eine Trennschicht umfasst. der Aktor umfasst eine magnetische Formgedächtnislegierung. Innerhalb des Verfahrens wird der Aktor bereitgestellt und eine Trennschicht auf zumindest eine Seite des Aktors aufgebracht.

Die Trennschicht kann auf zumindest 80% der Gesamtoberfläche des Aktors aufgebracht werden. Insbesondere wird die Trennschicht auf zumindest 90% der Gesamtoberfläche des Aktors aufgebracht. Besonders bevorzugt wird die Trennschicht auf die gesamte Oberfläche des Aktors aufgebracht.

Die Trennschicht kann eine Folie sein, speziell eine Kunststofffolie. Die Folie kann ein Ventil umfassen.

Die Folie kann um den Aktor angeordnet oder gelegt werden und zwischen der Folie und dem Aktor kann ein Vakuum erzeugt werden. Dadurch legt sich die Folie dicht an den Aktor an.

Die Folie kann an zumindest einer Stelle verschweißt werden.

Zwischen der Trennschicht und dem Aktor kann eine Flüssigkeit eingebracht. Speziell kann es sich bei der Flüssigkeit um Silikonöl (Diorganopolysiloxan) handeln.

Die Trennschicht kann durch eine Phasenumwandlung auf den Aktor aufgebracht werden.

Speziell handelt es sich bei der Phasenumwandlung um eine Umwandlung aus einer Gasphase in eine Feststoffphase.

Bei der Phasenumwandlung kann es sich spezifisch um eine Resublimation handeln.

Speziell wird ein Parylen auf den Aktor aufgebracht, um eine Beschichtung auf dem Aktor zu bilden.

Die Ausführungsformen der Erfindung sind anhand von einem Beispiel dargestellt und nicht auf eine Weise, in der Beschränkungen aus den Figuren in die Patentansprüche übertragen oder hineingelesen werden. Gleiche Bezugszeichen in den Figuren geben gleiche Elemente an.
- Figur 1a: zeigt eine Transportvorrichtung 100 in einer schematischen, teilweise geschnittenen Ansicht;
- Figur 1b: zeigt die Transportvorrichtung 100 in einer schematischen Vorderansicht;
- Figur 1c: zeigt die Transportvorrichtung 100 in einer schematischen Seitenansicht;
- Figur 1d: zeigt die Transportvorrichtung 100 in einer schematischen Draufsicht;
- Figur 2a: zeigt eine Transportvorrichtung 200 in einer schematischen, teilweise geschnittenen Ansicht;
- Figur 2b: zeigt die Transportvorrichtung 200 in einer schematischen Vorderansicht;
- Figur 2c: zeigt die Transportvorrichtung 200 in einer schematischen Seitenansicht;
- Figur 2d: zeigt die Transportvorrichtung 200 in einer schematischen Draufsicht;
- Figur 3a: zeigt eine Transportvorrichtung 300 in einer schematischen, teilweise geschnittenen Ansicht;
- Figur 3b: zeigt die Transportvorrichtung 300 in einer schematischen Vorderansicht;
- Figur 3c: zeigt die Transportvorrichtung 300 in einer schematischen Seitenansicht;
- Figur 3d: zeigt die Transportvorrichtung 300 in einer schematischen Draufsicht;
- Figur 4: zeigt eine Transportvorrichtung 400 in einer Explosionsdarstellung;
- Figur 5: zeigt eine Transportvorrichtung 500 in einer Explosionsdarstellung;
- Figur 6a: zeigt eine Transportvorrichtung 600 in einer schematischen, teilweise geschnittenen Ansicht;
- Figur 6b: zeigt die Transportvorrichtung 600 in einer schematischen Vorderansicht;
- Figur 6c: zeigt die Transportvorrichtung 600 in einer schematischen Seitenansicht;
- Figur 6d: zeigt die Transportvorrichtung 600 in einer schematischen Draufsicht;
- Figur 7: zeigt eine Transportvorrichtung 700 mit einem Rückstellelement 785 in einer schematischen Draufsicht;
- Figur 8: zeigt eine Transportvorrichtung 800 mit einem Rückstellelement 886, 886' in einer schematischen Draufsicht;
- Figur 9: zeigt eine Transportvorrichtung 900 mit einem Rückstellelement 987, 987' in einer schematischen Draufsicht;
- Figur 10a: zeigt eine Transportvorrichtung 1000 in einer schematischen, teilweise geschnittenen Ansicht;
- Figur 10b: zeigt die Transportvorrichtung 1000 in einer schematischen Vorderansicht;
- Figur 10c: zeigt die Transportvorrichtung 1000 in einer schematischen Seitenansicht;
- Figur 10d: zeigt die Transportvorrichtung 1000 in einer schematischen Draufsicht;
- Figur 11a: zeigt eine Transportvorrichtung 1100 in einer schematischen, teilweise geschnittenen Ansicht;
- Figur 11b: zeigt die Transportvorrichtung 1100 in einer schematischen Vorderansicht;
- Figur 11c: zeigt die Transportvorrichtung 1100 in einer schematischen Seitenansicht;
- Figur 11d: zeigt die Transportvorrichtung 1100 in einer schematischen Draufsicht;
- Figur 12a: zeigt eine Transportvorrichtung 1200 mit Sensoren 1290, 1291, 1292, 1293, 1294, 1295 in einer schematischen Vorderansicht;
- Figur 12b: zeigt die Transportvorrichtung 1200 mit Sensoren 1290, 1292, 1295 in einer schematischen Seitenansicht;
- Figur 13a: zeigt einen Aktor 13330 mit einer Trennschicht 1380;
- Figur 13b: zeigt einen Aktor 13330 mit einer Trennschicht 1380 und zwei Kavitäten 1335a, 1335b.

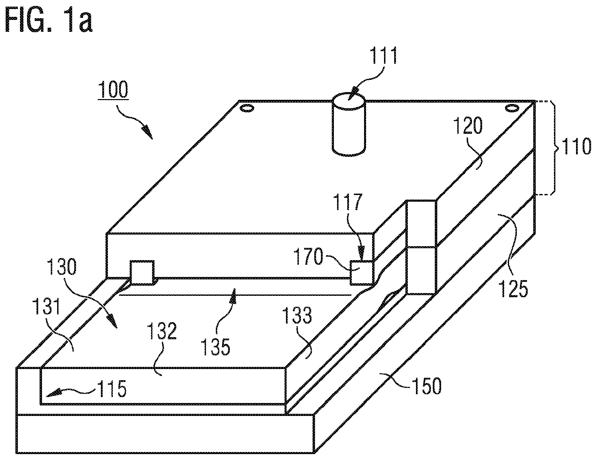

In den Figuren 1a bis 1d ist eine Ausführungsform einer Transportvorrichtung 100 dargestellt.

Speziell handelt es sich bei der Transportvorrichtung 100 um eine Pumpe, noch spezieller um eine Mikropumpe. In Figur 1a ist die Transportvorrichtung 100 in einer perspektivischen und schematischen Darstellung mit einigen Ausbrüchen dargestellt. Die Transportvorrichtung 100 umfasst ein Gehäuse 110, einen Aktor 130, einen Antrieb 150 und ein Dichtelement 170.

Der Aktor 130 umfasst eine magnetische Formgedächtnislegierung, sodass durch ein passendes Magnetfeld eine Formveränderung des Aktors 130 herbeigeführt werden kann. Der Aktor 130 kann aus der magnetischen Formgedächtnislegierung bestehen.

Typischerweise ist die Grundform des Aktors 130 im Wesentlichen quaderförmig mit zwei Seitenflächen, zwei Stirnflächen und zwei Flächen, in denen Einschnürungen oder Einbuchtungen als Kavitäten gebildet werden sollen. Die Flächen, in denen Kavitäten gebildet werden sollen, werden auch als Kavitätsflächen bezeichnet. Die Flächen der Kavitätsflächen sind größer als die Flächen der Stirnflächen und der Seitenflächen, bevorzugt sind die Flächen der Kavitätsflächen um mindestens den Faktor 3 größer als die Flächen der Stirnflächen oder der Seitenflächen.

Mit Blick auf eine der Kavitätsflächen ist eine Kavität 135 in dem Aktor 130 gebildet. Die Kavität 135 verläuft typischerweise zwischen den Seitenflächen des Aktors 130 (insbesondere vollständig). Zwischen den Stirnflächen ist die Kavität 135 nur abschnittsweise in der Kavitätsfläche des Aktors 130 ausgebildet. Auf der der betrachteten Kavitätsfläche gegenüberliegenden Kavitätsfläche (dem Antrieb 150 zugewandt) kann ebenso eine Kavität ausgebildet sein.

Der Aktor 130 ist in dem Gehäuse 110 angeordnet. Speziell ist der Aktor 130 in dem Gehäuse 110 so angeordnet, dass alle Flächen des Aktors 130 (Kavitätsflächen 131, Stirnflächen 132, Seitenflächen 133) von dem Gehäuse 110 umschlossen sind.

Das Gehäuse 110 umfasst einen ersten Gehäuseabschnitt 120 und einen zweiten Gehäuseabschnitt 125. Der erste und der zweite Gehäuseabschnitt 120, 125 sind zu dem Gehäuse 110 beispielsweise durch eine Verschraubung verbunden. Das Gehäuse 110 mit dem ersten Gehäuseabschnitt 120 und dem zweiten Gehäuseabschnitt 125 kann ebenso einstückig ausgebildet sein.

Das Gehäuse 110, speziell der zweite Gehäuseabschnitt 125, weist eine Einbuchtung 115 auf, in die der Aktor 130 passend eingebracht werden kann.

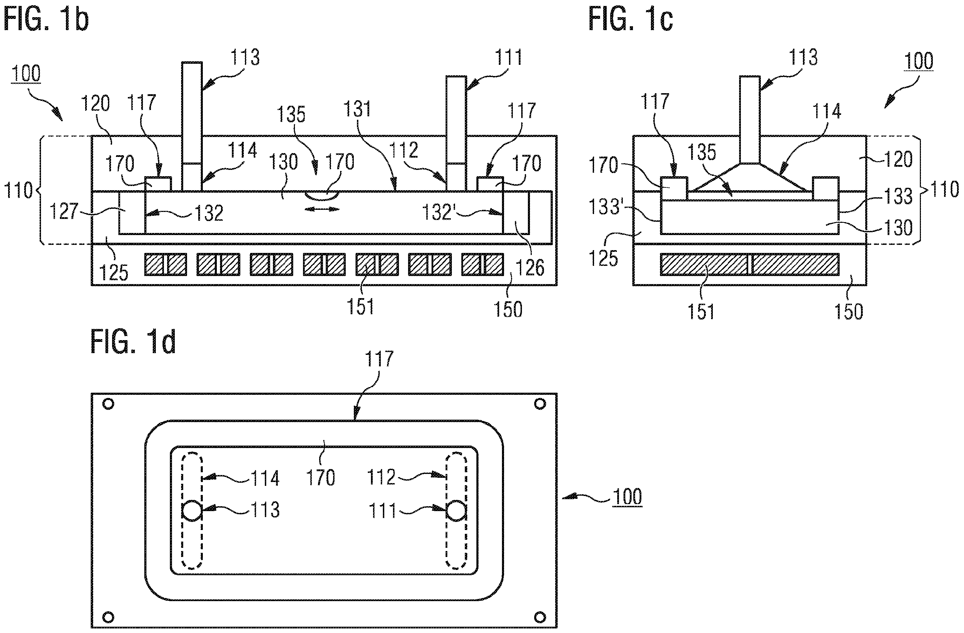

In dem Gehäuse 110, speziell in dem ersten Gehäuseabschnitt 120, ist eine Nut 117 vorgesehen, in die das Dichtelement 170 eingebracht ist. Der Verlauf der Nut 117 wird mit Blick auf die Figuren 1b bis 1d ausführlicher beschrieben werden.

Das Dichtelement 170 weist eine elastische Eigenschaft auf. In einem Bereich der Kavitätsfläche 131, in dem keine Kavität gebildet ist, liegt das Dichtelement 170 an der Kavitätsfläche 131 des Aktors 130 an, wobei das Dichtelement 170 bündig mit der unteren Fläche des ersten Gehäuseabschnitts 120 ist, das Dichtelement 170 also vollständig in der Nut 117 liegt und nicht aus der Nut 117 hinausragt. In einem Bereich der Kavitätsfläche 131 des Aktors 130, in dem eine Kavität 135 gebildet ist, liegt das Dichtelement 170 ebenso an der Kavitätsfläche 131 des Aktors 130 an, wobei in diesem Bereich das Dichtelement 170 nicht bündig mit dem ersten Gehäuseabschnitt 120 des Gehäuses 110 ist, das Dichtelement 170 also nicht vollständig in der Nut 117 angeordnet ist, sondern teilweise aus der Nut 117 hinausragt.

Bewegt sich die Kavität 135 von einer Stirnfläche zu der anderen Stirnfläche, verändert sich die Lage des Abschnitts des Dichtelements 170, der aus der Nut 117 hinausragt und im Bereich der Kavität 135 an der Kavitätsfläche 131 des Aktors 130 anliegt.

Durch die Ausgestaltung und Anordnung des Dichtelements 170 innerhalb der Transportvorrichtung 100 ist die Kavität 135 unabhängig von ihrer Position (innerhalb eines Bereichs) stets randseitig (in Richtung der Seitenflächen) abgedichtet. Die Kavität 135 wird während des Transports begrenzt durch den Aktor 130, das Dichtelement 170 und das Gehäuse 110 (speziell durch den ersten Gehäuseabschnitt 120). Ist die Kavität 135 in einem Bereich des Aktors 130 gebildet, der eine Fluidkommunikation mit einem in dem Gehäuse 110 angeordneten Fluideinlass 111 erlaubt, kann das Fluid über den Fluideinlass 111 in die Kavität 135 einströmen und kann an eine andere Position transportiert werden.

Figur 1b zeigt die Transportvorrichtung 100 in einer schematischen Vorderansicht. Die Transportvorrichtung 100 umfasst ein Gehäuse 110, das einen ersten Gehäuseabschnitt 120 und einen zweiten Gehäuseabschnitt 125 umfasst, einen Aktor 130, einen Antrieb 150 und ein Dichtelement 170. In dem Gehäuse sind ein Fluideinlass 111 und ein Fluidauslass 113 angeordnet.

Der Fluideinlass 111 ist mit einem ersten Diffusor 112 verbunden und der Fluidauslass 113 ist mit einem zweiten Diffusor 114 verbunden. Das Gehäuse 110, insbesondere der erste Gehäuseabschnitt 120, umfasst eine Nut 117, in der das Dichtelement angeordnet ist. In dem Aktor 130 ist eine Kavität 135 gebildet. Der Antrieb 150 umfasst mehrere Magneten 151, die entlang der Längserstreckung des Aktors angeordnet sind. Die Magnete 151 können Elektromagnete und/oder Permanentmagnete sein. Die Magnete 151 sind bevorzugt entlang der gesamten Länge des Aktors 130 angeordnet.

Durch eine Veränderung des Magnetfelds, erzeugt durch die Magneten 151, entlang des Aktors 130, ist eine Bewegung der Kavität 135 in dem Aktor 130 möglich. Speziell kann die Kavität 135 zwischen dem Fluideinlass 111 und dem Fluidauslass 113 bewegt werden, sodass ein Fluid über den Fluideinlass 111 in die Kavität 135 einströmen kann, wenn die Kavität 135 fluidkommunizierend mit dem Fluideinlass 111 verbunden ist, die mit dem Fluid gefüllte Kavität 135 in Richtung des Fluidauslasses 113 bewegt werden und das Fluid in der Kavität 135 kann aus dem Fluidauslass 113 ausströmen, wenn die Kavität 135 fluidkommunizierend mit dem Fluidauslass 113 verbunden ist.

Während der Bewegung der Kavität 135 von dem Fluideinlass 111 zu dem Fluidauslass 113 ist diese begrenzt durch den Aktor 130 (insbesondere die Kavitätsfläche 131), das Gehäuse 110 (insbesondere der erste Gehäuseabschnitt 120) und randseitig und/oder endseitig durch das Dichtelement 170.

In dem Gehäuse 110, speziell in dem zweiten Gehäuseabschnitt 125, sind zwei Einspannelemente 126, 127 angeordnet. Das erste Einspannelement 126 ist dabei so in dem Gehäuse 110 angeordnet, dass dieses zumindest abschnittsweise eine Stirnfläche 132' des Aktors 130 kontaktiert und das zweite Einspannelement 127 ist in dem Gehäuse 110 so angeordnet, dass dieses eine andere Stirnfläche 132 des Aktors 130 zumindest abschnittsweise kontaktiert.

Wird in dem Aktor eine Kavität als Einschnürung oder Einbuchtung durch den Antrieb 150 gebildet, dehnt sich der Aktor 130 an anderer Stelle aus, da die Einschnürung oder Kavitätsbildung volumenstabil erfolgt. Eine Rückstellung der Kavität erfolgt nicht ohne Veranlassung, sondern kann mechanisch oder magnetisch erfolgen. Die Einspannelemente 126, 127 können eine elastische Eigenschaft aufweisen, sodass stirnseitig 132, 132' eine vergrößerte Kraft auf den Aktor 130 ausgeübt wird, wenn eine Kavität 135 in dem Aktor 130 gebildet wird und sich der Aktor 130 in Richtung der Stirnflächen 132, 132' ausgedehnt hat. Durch ein Abschalten des Magnetfelds wird stirnseitig 132, 132' eine Kraft von den Einspannelementen 126, 127 auf den Aktor 130 ausgeübt, sodass sich die Kavität 135 rückstellt. Die Rückstellung kann auch durch ein anders orientiertes Magnetfeld, z. B. durch Magneten in den Einspannelementen 126, 127, erfolgen, wobei sich die andere Orientierung auf die Orientierung des Magnetfelds des Antriebs 150 bezieht, das zur Bildung der Kavität 125 erzeugt wurde.

Figur 1c zeigt die Transportvorrichtung 100 schematisch und geschnitten in einer Seitenansicht.

Der Fluidauslass 113 ist fluidkommunizierend mit dem zweiten Diffusor 114 verbunden. Die Kavität 135 in dem Aktor 130 ist fluidkommunizierend mit dem Diffusor 114 verbunden und dadurch auch fluidkommunizierend mit dem Fluidauslass 113 verbunden. Das Fluid in der Kavität 135 kann über den Diffusor 114 und den Fluidauslass 113 aus der Transportvorrichtung 100 ausströmen.

Die Querschnittsfläche des Diffusors ist an dem Ende des Diffusors, das dem Aktor 130 zugewandt ist, größer als die Querschnittsfläche des Endes des Diffusors 114, das dem Aktor 130 abgewandt ist.

Der erste Diffusor 112 des Fluideinlasses 111 kann gleich zu dem zweiten Diffusor 114 des Fluidauslasses 113 ausgestaltet sein.

Das Dichtelement 170 in der Nut 117 ragt aus der Nut 117 hinaus, um den Aktor 130, insbesondere die Kavitätsfläche 131, zu kontaktieren, da in dem Aktor 130 der Figur 1c eine Kavität 135 vorhanden ist. Durch das Dichtelement 170 ist die Kavität 135 randseitig abgedichtet.

In Figur 1d ist die Transportvorrichtung 100 in einer schematischen Draufsicht dargestellt, wobei die Nut 117 in dem Gehäuse 110 angedeutet ist. In der Nut 117 ist das Dichtelement 170 angeordnet.

Die Nut 117 mit dem Dichtelement 170 umschließt einen Bereich oder Flächenabschnitt des Gehäuses 110, insbesondere des ersten Gehäuseabschnitts 120, in dem das Fluid von dem Fluideinlass 111 über den angedeuteten Diffusor 112 zu dem Fluidauslass 113 über den angedeuteten Diffusor 114 transportiert werden kann. In Richtung einer Achse zwischen dem Fluideinlass 111 und dem Fluidauslass 113 ist die Kavität 135 durch das Dichtelement 170 endseitig abgedichtet und in Richtung einer weiteren Achse, die senkrecht zu der ersten Achse ist, ist die Kavität 135 durch das Dichtelement 170 randseitig abgedichtet. Durch diese Abdichtung wird eine Leckage von Fluid in einer Kavität 135 reduziert oder sogar vermieden und die hydraulische Leistung der Transportvorrichtung (Pumpe) verbessert.

Die Grundform der Nut 117 und des Dichtelements 170 entspricht im Wesentlichen der Grundform des Aktors 130.

Das Dichtelement 170 kann eine rechteckringartige Form aufweisen, speziell mit abgerundeten Ecken.

Insbesondere die Fläche oder die Flächen des Gehäuses 100, die mit einem Fluid z.B. in der Kavität in Kontakt geraten können, können mit PTFE beschichtet sein.

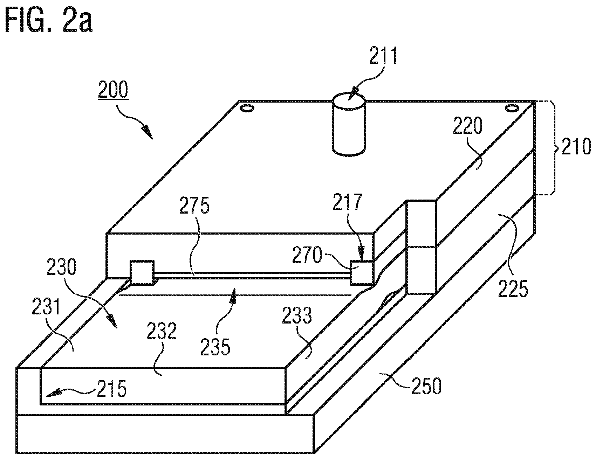

Die Figuren 2a bis 2d zeigen eine Ausführungsform einer Transportvorrichtung 200.

Die Transportvorrichtung 200 kann eine Pumpe sein, noch spezieller eine Mikropumpe sein. In Figur 2a ist die Transportvorrichtung 200 in einer perspektivischen und schematischen Darstellung mit Ausbrüchen dargestellt. Die Transportvorrichtung 200 umfasst ein Gehäuse 210, einen Aktor 230, einen Antrieb 250, ein erstes Dichtelement 270 und ein zweites Dichtelement 275.

Der Aktor 230 umfasst eine magnetische Formgedächtnislegierung, sodass durch ein passendes Magnetfeld eine Formveränderung des Aktors 230 herbeigeführt werden kann. Der Aktor 230 kann aus der magnetischen Formgedächtnislegierung bestehen.

Die Grundform des Aktors 230 kann im Wesentlichen quaderförmig sein, dies mit zwei Seitenflächen, zwei Stirnflächen und zwei Kavitätsflächen, in denen Einschnürungen oder Einbuchtungen als Kavitäten gebildet werden sollen. Die Flächen der Kavitätsflächen sind größer als die Flächen der Stirnflächen und der Seitenflächen, bevorzugt sind die Flächen der Kavitätsflächen um mindestens den Faktor 3 größer als die Flächen der Stirnflächen oder der Seitenflächen.

In einer der Kavitätsflächen ist eine Kavität 235 in dem Aktor 230 gebildet. Die Kavität 235 verläuft typischerweise zwischen den Seitenflächen des Aktors 230 (insbesondere vollständig). Zwischen den Stirnflächen ist die Kavität 235 nur abschnittsweise in der Kavitätsfläche des Aktors 230 ausgebildet. Auf der der betrachteten Kavitätsfläche gegenüberliegenden Kavitätsfläche (dem Antrieb 250 zugewandt) ist typischerweise ebenso eine Kavität ausgebildet.

Der Aktor 230 ist in dem Gehäuse 210 angeordnet. Insbesondere ist der Aktor 230 in dem Gehäuse 210 so angeordnet, dass alle Flächen des Aktors 230 (Kavitätsflächen 231, Stirnflächen 232, Seitenflächen 233) von dem Gehäuse 210 umschlossen sind.

Das Gehäuse 210 umfasst einen ersten Gehäuseabschnitt 220 und einen zweiten Gehäuseabschnitt 225. Der erste und der zweite Gehäuseabschnitt 220, 225 sind zu dem Gehäuse 210 beispielsweise durch eine Verschraubung verbunden. Das Gehäuse 210 mit dem ersten Gehäuseabschnitt 220 und dem zweiten Gehäuseabschnitt 225 kann ebenso einstückig ausgebildet sein.

Das Gehäuse 210, speziell der zweite der Gehäuseabschnitt 225, weist eine Einbuchtung 215 auf, in die der Aktor 230 passend eingebracht werden kann.

Das Gehäuse 210, speziell der erste Gehäuseabschnitt 220, umfasst eine Nut 217. In diese ist das erste Dichtelement 270 eingebracht.

Das erste Dichtelement 270 weist eine elastische Eigenschaft auf. In einem Bereich der Kavitätsfläche 231, in dem keine Kavität gebildet ist, liegt das erste Dichtelement 270 an der Kavitätsfläche 231 des Aktors 230 an, wobei das Dichtelement 270 bündig mit dem zweiten Dichtelement 275 und mit einem Abschnitt der unteren Fläche des ersten Gehäuseabschnitts 220 ist. Das erste Dichtelement 270 ragt also nicht über die Erstreckung des zweiten Dichtelements 275 in Richtung des Aktors 230 hinaus. In einem Bereich der Kavitätsfläche 231 des Aktors 230, in dem eine Kavität 235 gebildet ist, liegt das erste Dichtelement 270 ebenso an der Kavitätsfläche 231 des Aktors 230 an, wobei in diesem Bereich das erste Dichtelement 270 nicht bündig mit dem zweiten Dichtelement 275 und dem ersten Gehäuseabschnitt 220 des Gehäuses 210 ist. Das erste Dichtelement 270 ragt also in Richtung des Aktors 230 über die Erstreckung (in gleicher Richtung) des zweiten Dichtelements 275 hinaus.

Bei einer Bewegung der Kavität 235 von einer Stirnfläche 232 zu der anderen Stirnfläche 232' durch den Antrieb 250, verändert sich die Lage des Abschnitts des ersten Dichtelements 270, der über die Erstreckung des zweiten Dichtelements 275 in Richtung des Aktors 230 hinausragt und im Bereich der Kavität 235 an der Kavitätsfläche 231 des Aktors 230 anliegt.

Durch die Ausgestaltung und Anordnung des ersten Dichtelements 270 innerhalb der Transportvorrichtung 200 ist die Kavität 235 unabhängig von ihrer Position (innerhalb eines Bereichs) stets randseitig (in Richtung der Seitenflächen) abgedichtet.

An einem Bereich des Aktors 230, in dem keine Kavität 235 gebildet ist, liegt auch (zusätzlich zu dem ersten Dichtelement 270) das zweite Dichtelement 275 an.

Die Kavität 235 wird während des Transports begrenzt durch den Aktor 230 (Kavitätsfläche 231 des Aktors), das erste Dichtelement 270 und das zweite Dichtelement 275. Ist die Kavität 235 in einem Bereich des Aktors 230 gebildet, der eine Fluidkommunikation mit einem in dem Gehäuse 210 angeordneten Fluideinlass 211 erlaubt, kann das Fluid über den Fluideinlass 211 in die Kavität 235 einströmen und kann an eine andere Position transportiert werden.

Die elastische Rückstellung des ersten Dichtelements 270 kann größer sein als die elastische Rückstellung des zweiten Dichtelements 275, sodass die Kavität 235 im Wesentlichen lediglich von dem ersten Dichtelement 230 kontaktiert wird.

Das zweite Dichtelement 275 kann flächig ausgestaltet sein. Es kann von dem ersten Dichtelement 270 vollständig umschlossen sein.

Das zweite Dichtelement 275 kann dünner ausgestaltet sein als das erste Dichtelement 230.

Das zweite Dichtelement 275 kann Ausnehmungen aufweisen, die zu der Ausgestaltung des Fluideinlasses 211 und des Fluidauslasses 213, ggf. mit verbundenen Diffusoren 212, 214, korrespondieren.

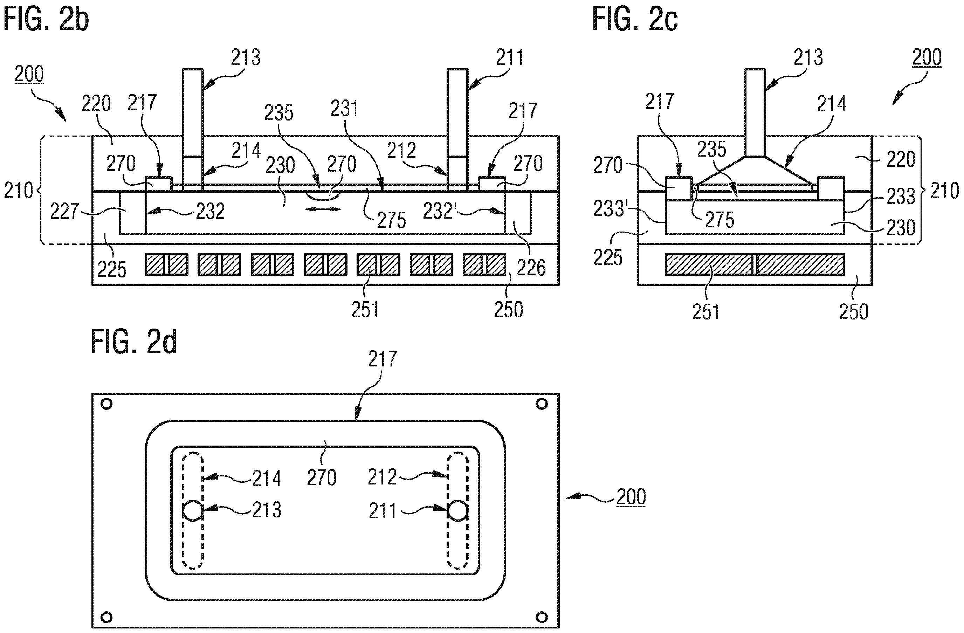

In Figur 2b ist die Transportvorrichtung 200 in einer schematischen Vorderansicht dargestellt. Die Transportvorrichtung 200 umfasst ein Gehäuse 210, das einen ersten Gehäuseabschnitt 220 und einen zweiten Gehäuseabschnitt 225 umfasst, einen Aktor 230, einen Antrieb 250 und ein Dichtelement 270. Das Gehäuse 210 umfasst einen Fluideinlass 211 und einen Fluidauslass 213.

Der Fluideinlass 211 ist mit einem ersten Diffusor 212 verbunden und der Fluidauslass 213 ist mit einem zweiten Diffusor 214 verbunden. Das Gehäuse 210, insbesondere der erste Gehäuseabschnitt 220, umfasst eine Nut 217, in der das erste Dichtelement 270 angeordnet ist. Das zweite Dichtelement 275 ist an einer Fläche des Gehäuses 210, speziell an dem ersten Gehäuseabschnitt 220, angeordnet, die dem Aktor 230 zugewandt ist. In dem Aktor 230 ist eine Kavität 235 gebildet. Der Antrieb 250 umfasst mehrere Magneten 251, die entlang der Längserstreckung des Aktors 230 angeordnet sind. Die Magnete 251 können Elektromagnete und/oder Permanentmagnete sein. Die Magnete 251 sind bevorzugt entlang der gesamten Länge des Aktors 230 angeordnet.

Die Kavität 235 kann entlang des Aktors 230, durch ein durch die Magneten 251 erzeugtes Magnetfeld, bewegt werden. Speziell kann die Kavität 235 zwischen dem Fluideinlass 211 und dem Fluidauslass 213 bewegt werden, sodass ein Fluid über den Fluideinlass 211 in die Kavität 235 einströmen kann, wenn die Kavität 235 fluidkommunizierend mit dem Fluideinlass 211 verbunden ist, die mit dem Fluid gefüllte Kavität 235 in Richtung des Fluidauslasses 213 bewegt werden und das Fluid in der Kavität 235 kann aus dem Fluidauslass 213 ausströmen, wenn die Kavität 235 fluidkommunizierend mit dem Fluidauslass 213 verbunden ist.

Während der Bewegung der Kavität 235 von dem Fluideinlass 211 zu dem Fluidauslass 213 ist diese begrenzt durch den Aktor 230 (insbesondere durch die Kavitätsfläche 231), das zweite Dichtelement 275 und randseitig und/oder endseitig durch das erste Dichtelement 270.

In dem Gehäuse 210, speziell in dem zweiten Gehäuseabschnitt 225, sind zwei Einspannelemente 226, 227 angeordnet. Das erste Einspannelement 226 ist dabei so in dem Gehäuse 210 angeordnet, dass dieses zumindest abschnittsweise eine Stirnfläche 232' des Aktors 230 kontaktiert und das zweite Einspannelement 227 ist in dem Gehäuse 210 so angeordnet, dass dieses eine andere Stirnfläche 232 des Aktors 230 zumindest abschnittsweise kontaktiert.

Die Einspannelemente 226, 227 können eine elastische Eigenschaft aufweisen, sodass stirnseitig 232, 232' eine vergrößerte Kraft auf den Aktor 230 ausgeübt wird, wenn eine Kavität 235 in dem Aktor 230 gebildet wird und sich der Aktor 230 in Richtung der Stirnflächen 232, 232' ausgedehnt hat. Durch ein Abschalten des Magnetfelds wird stirnseitig 232, 232' eine Kraft von den Einspannelementen 226, 227 auf den Aktor 230 ausgeübt, sodass sich die Kavität 235 rückstellt. Die Rückstellung kann auch durch ein anders orientiertes Magnetfeld, z. B. durch Magneten in den Einspannelementen 226, 227, erfolgen.

Figur 2c zeigt die Transportvorrichtung 200 schematisch und geschnitten in einer Seitenansicht.

Der Fluidauslass 223 ist fluidkommunizierend mit dem zweiten Diffusor 224 verbunden. Die Kavität 235 in dem Aktor 230 ist fluidkommunizierend mit dem Diffusor 214 verbunden und dadurch auch fluidkommunizierend mit dem Fluidauslass 213 verbunden. Das Fluid in der Kavität 235 kann über den Diffusor 214 und den Fluidauslass 213 aus der Transportvorrichtung 200 ausströmen.

Die Querschnittsfläche des Diffusors ist an dem Ende des Diffusors, das dem Aktor 230 zugewandt ist, größer sein als die Querschnittsfläche des Endes des Diffusors 214, das dem Aktor 230 abgewandt ist.

Der erste Diffusor des Fluideinlasses 210 kann gleich zu dem zweiten Diffusor 214 des Fluidauslasses ausgestaltet sein.

Das zweite Dichtelement 275 weist Ausnehmungen auf, die im Wesentlichen der Form des Endes der Diffusoren 212, 214 entsprechen, das dem Aktor 230 zugewandt ist.

Das erste Dichtelement 270 in der Nut 217 ragt über das zweite Dichtelement 275 in Richtung des Aktors 230 und aus der Nut 217 hinaus, um den Aktor 230, insbesondere die Kavitätsfläche 231, zu kontaktieren, da in dem Aktor 230 der Figur 2c eine Kavität 235 vorhanden ist. Durch das erste Dichtelement 270 ist die Kavität 235 randseitig abgedichtet.

Figur 2d zeigt die Transportvorrichtung 200 in einer schematischen Draufsicht. Die Nut 217 ist in dem Gehäuse 210 angedeutet. In der Nut 217 ist das erste Dichtelement 270 angeordnet, das zweite Dichtelement 275 liegt flächig (mit Ausnehmungen für die Diffusoren) an dem Gehäuse 210 an, wobei das erste Dichtelement 270 das zweite Dichtelement 275, insbesondere vollständig, umschließt oder dieses umläuft.

Die Nut 217 mit dem ersten Dichtelement 270 umschließt einen Bereich oder Flächenabschnitt des Gehäuses 210, insbesondere des ersten Gehäuseabschnitts 220, in dem das Fluid von dem Fluideinlass 211 über den angedeuteten Diffusor 212 zu dem Fluidauslass 213 über den angedeuteten Diffusor 214 transportiert werden kann. In Richtung einer Achse zwischen dem Fluideinlass 211 und dem Fluidauslass 213 ist die Kavität 235 durch das erste Dichtelement 270 endseitig abgedichtet. In Richtung einer weiteren Achse, die senkrecht zu der ersten Achse ist, ist die Kavität 235 durch das erste Dichtelement 270 randseitig abgedichtet. Durch diese Abdichtung wird eine Leckage von einem Fluid in einer Kavität 235 reduziert oder sogar vermieden und die hydraulische Leistung der Transportvorrichtung (Pumpe) verbessert.

Die Grundform der Nut 217 und des ersten Dichtelements 270 entspricht im Wesentlichen der Grundform des Aktors 230.

Das erste Dichtelement 270 kann eine rechteckringartige Form aufweisen, speziell mit abgerundeten Ecken. Das zweite Dichtelement 270 ist bevorzugt flächig mit einer rechteckartigen Grundform, wobei die Ecken abgerundet sind.

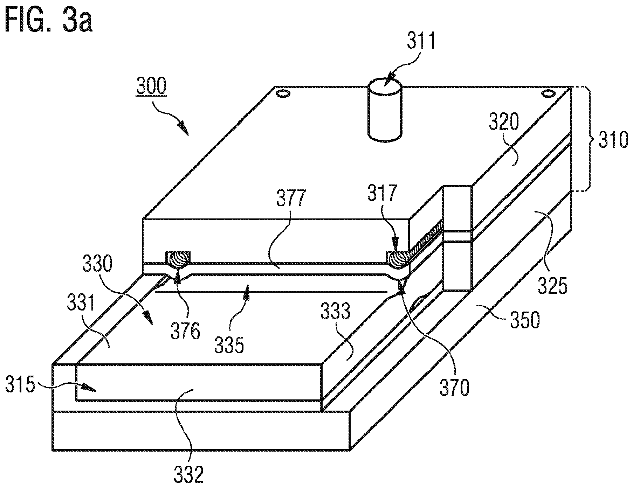

In den Figuren 3a bis 3d ist eine Ausführungsform einer Transportvorrichtung 300 dargestellt. Die Transportvorrichtung 300 kann eine Pumpe, noch spezieller eine Mikropumpe, sein.

In Figur 3a ist die Transportvorrichtung 300 in einer perspektivischen und schematischen Darstellung mit Ausbrüchen dargestellt. Die Transportvorrichtung 300 umfasst ein Gehäuse 310, einen Aktor 330, einen Antrieb 350 und ein Dichtelement 370. Das Dichtelement 370 umfasst eine Dichtbahn 377 und ein Federelement 376.

Der Aktor 330 umfasst eine magnetische Formgedächtnislegierung, sodass durch ein passendes Magnetfeld eine Formveränderung des Aktors 330 verursacht werden kann. Der Aktor 330 kann aus der magnetischen Formgedächtnislegierung bestehen.

Typischerweise ist die Grundform des Aktors 330 im Wesentlichen quaderförmig mit zwei Seitenflächen, zwei Stirnflächen und zwei Kavitätsflächen, in denen Einschnürungen oder Einbuchtungen als Kavitäten gebildet werden sollen. Die Flächen der Kavitätsflächen sind größer als die Flächen der Stirnflächen und der Seitenflächen, bevorzugt sind die Flächen der Kavitätsflächen um mindestens den Faktor 3 größer als die Flächen der Stirnflächen oder der Seitenflächen.

Mit Blick auf eine der Kavitätsflächen ist eine Kavität 335 in dem Aktor 330 gebildet. Die Kavitätsfläche, die der betrachteten Kavitätsfläche gegenüberliegt, kann ebenso eine Kavität aufweisen. Die Kavität 335 verläuft typischerweise zwischen den Seitenflächen des Aktors 330 (insbesondere vollständig). Zwischen den Stirnflächen ist die Kavität 335 nur abschnittsweise in der Kavitätsfläche des Aktors 330 ausgebildet.

Der Aktor 330 ist in dem Gehäuse 310 angeordnet. Speziell ist der Aktor 330 in dem Gehäuse 310 so angeordnet, dass alle Flächen des Aktors 330 (Kavitätsflächen 331, Stirnflächen 332, Seitenflächen 333) von dem Gehäuse 310 umschlossen sind, gegebenenfalls in Verbindung mit dem Dichtelement 370.

Das Gehäuse 310 umfasst einen ersten Gehäuseabschnitt 320 und einen zweiten Gehäuseabschnitt 325. Der erste und der zweite Gehäuseabschnitt 320, 325 sind zu dem Gehäuse 310 beispielsweise durch eine Verschraubung verbunden. Das Gehäuse 310 mit dem ersten Gehäuseabschnitt 320 und dem zweiten Gehäuseabschnitt 325 kann ebenso einstückig ausgebildet sein. Zwischen dem ersten Gehäuseabschnitt 320 und dem zweiten Gehäuseabschnitt 325 ist die Dichtbahn 377 des Dichtelements 310 angeordnet.

Das Gehäuse 310, speziell der zweite Gehäuseabschnitt 325, weist eine Einbuchtung 315 auf, in die der Aktor 330 passend eingebracht werden kann.

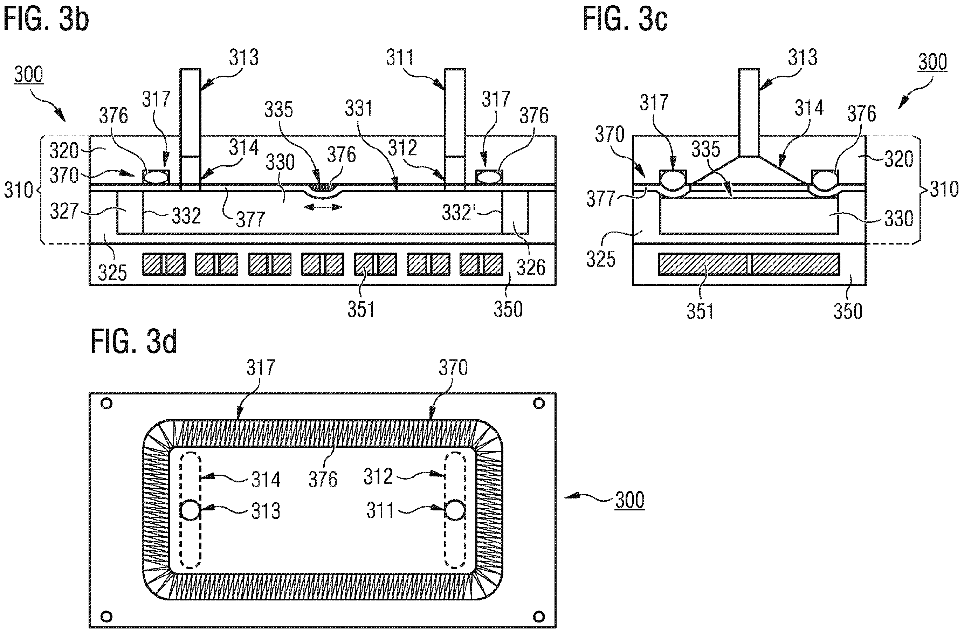

In dem Gehäuse 310, speziell in dem ersten Gehäuseabschnitt 320, ist eine Nut 317 vorgesehen, in die das Federelement 376 des Dichtelements 370 eingebracht ist. Der Verlauf der Nut 317 wird mit Blick auf die Figuren 3b bis 3d näher beschrieben werden.

Die Dichtbahn 377 kann eine elastische Eigenschaft aufweisen. Das Federelement 376 weist eine elastische (federnde) Eigenschaft auf, sodass das Dichtelement 370 eine elastische Eigenschaft aufweist. Das Dichtelement 370, insbesondere die Dichtbahn 377, liegt in einem Bereich der Kavitätsfläche 331, in dem keine Kavität gebildet ist, an der Kavitätsfläche 331 des Aktors 330 an, wobei die Dichtbahn 377 des Dichtelements 370 ebenflächig (umfasst keine Auswölbung aus der Fläche) ist und das Federelement 376, insbesondere vollständig, in der Nut 317 liegt und nicht aus der Nut 317 hinausragt. In einem Bereich der Kavitätsfläche 331 des Aktors 330, in dem eine Kavität 335 gebildet ist, liegt das Dichtelement 370, insbesondere die Dichtbahn 377, ebenso an der Kavitätsfläche 331 des Aktors 330 an, wobei in diesem Bereich die Dichtbahn 377 durch das Federelement 376 bereichsweise ausgewölbt (nicht ebenflächig) ist und das Federelement 376 des Dichtelements 370 nicht vollständig in der Nut 317 angeordnet ist, sondern teilweise aus der Nut 317 in Richtung des Aktors 330 hinausragt, um die Dichtbahn 377 abschnittsweise in die Kavität 335 zu drücken.

Bewegt sich die Kavität 335 von einer Stirnfläche 332 zu der anderen Stirnfläche 332, verändert sich die Lage des Abschnitts der Dichtbahn 377, der von dem Federelement 376 in Richtung der Kavität 335 gedrückt wird, und im Bereich der Kavität 335 an der Kavitätsfläche 331 des Aktors 330 anliegt.

Durch die Ausgestaltung und Anordnung des Dichtelements 370 innerhalb der Transportvorrichtung 300 ist die Kavität 335 unabhängig von ihrer Position (innerhalb eines Bereichs) stets randseitig (in Richtung der Seitenflächen) abgedichtet.

Die Kavität 335 wird während des Transports begrenzt durch den Aktor 330 und das Dichtelement 370 (die Dichtbahn 377 des Dichtelements 370). Ist die Kavität 335 in einem Bereich des Aktors 330 gebildet, der eine Fluidkommunikation mit einem in dem Gehäuse 330 angeordneten Fluideinlass 311 erlaubt, kann das Fluid über den Fluideinlass 311 in die Kavität 335 einströmen und kann an eine andere Position transportiert werden.

Figur 3b zeigt die Transportvorrichtung 300 in einer schematischen Vorderansicht. Die Transportvorrichtung 300 umfasst ein Gehäuse 310, das einen ersten Gehäuseabschnitt 320 und einen zweiten Gehäuseabschnitt 325 umfasst, einen Aktor 330, einen Antrieb 350 und ein Dichtelement 370 mit einer Dichtbahn 377 und einem Federelement 376. In dem Gehäuse 310 sind ein Fluideinlass 311 und ein Fluidauslass 313 angeordnet.

Der Fluideinlass 311 ist mit einem ersten Diffusor 312 verbunden und der Fluidauslass 313 ist mit einem zweiten Diffusor 314 verbunden. Das Gehäuse 310, insbesondere der erste Gehäuseabschnitt 320, umfasst eine Nut 317, in der das Dichtelement 370, speziell das Federelement 376 des Dichtelements 370, angeordnet ist. In dem Aktor 330 ist eine Kavität 335 gebildet. Der Antrieb 350 umfasst mehrere Magneten 351, die entlang der Längserstreckung des Aktors 330 angeordnet sind. Die Magnete 351 können Elektromagnete und/oder Permanentmagnete sein. Die Magnete 351 sind bevorzugt entlang der gesamten Länge des Aktors 330 angeordnet.

Durch eine Veränderung des Magnetfelds, erzeugt durch die Magneten 351, entlang des Aktors 330, ist eine Bewegung der Kavität 335 in dem Aktor 330 möglich. Speziell kann die Kavität 335 zwischen dem Fluideinlass 311 und dem Fluidauslass 313 bewegt werden, sodass ein Fluid über den Fluideinlass 311 in die Kavität 335 einströmen kann, wenn die Kavität 335 fluidkommunizierend mit dem Fluideinlass 311 verbunden ist, die mit dem Fluid gefüllte Kavität 335 in Richtung des Fluidauslasses 313 bewegt werden und das Fluid in der Kavität 335 kann aus dem Fluidauslass 313 ausströmen, wenn die Kavität 335 fluidkommunizierend mit dem Fluidauslass 313 verbunden ist.

Während der Bewegung der Kavität 335 von dem Fluideinlass 311 zu dem Fluidauslass 313 ist diese begrenzt durch den Aktor 330 (insbesondere die Kavitätsfläche 331), das Gehäuse 310 (insbesondere der erste Gehäuseabschnitt 320) und randseitig und/oder endseitig durch die Dichtbahn 377 des Dichtelements 370 in Verbindung mit dem Federelement 376 des Dichtelements 370.

In dem Gehäuse 310, speziell in dem zweiten Gehäuseabschnitt 325, sind zwei Einspannelemente 326, 327 angeordnet. Das erste Einspannelement 326 ist dabei so in dem Gehäuse 310 angeordnet, dass dieses zumindest abschnittsweise eine Stirnfläche 332' des Aktors 330 kontaktiert und das zweite Einspannelement 327 ist in dem Gehäuse 310 so angeordnet, dass dieses eine andere Stirnfläche 332 des Aktors 330 zumindest abschnittsweise kontaktiert.

Eine Rückstellung der Kavität kann mechanisch oder magnetisch erfolgen. Die Einspannelemente 326, 327 können eine elastische Eigenschaft aufweisen, sodass stirnseitig 332, 332' eine vergrößerte Kraft auf den Aktor 330 ausgeübt wird, wenn eine Kavität 335 in dem Aktor 330 gebildet wird und sich der Aktor 330 in Richtung der Stirnflächen 332, 332' ausdehnt. Durch ein Abschalten des Magnetfelds wird stirnseitig 332, 332' eine Kraft von den Einspannelementen 326, 327 aus den Aktor 330 ausgeübt, sodass sich die Kavität 335 rückstellt. Die Rückstellung kann auch durch ein anders orientiertes Magnetfeld, z. B. durch Magneten in den Einspannelementen 326, 327, erfolgen.

Die in Figur 3c schematisch und geschnitten in einer Seitenansicht gezeigte Transportvorrichtung 300 umfasst den Fluidauslass 313, der fluidkommunizierend mit dem zweiten Diffusor 314 verbunden ist. Die Kavität 335 in dem Aktor 330 ist fluidkommunizierend mit dem Diffusor 314 verbunden und dadurch auch fluidkommunizierend mit dem Fluidauslass 313 verbunden. Das Fluid in der Kavität 335 kann über den Diffusor 314 und den Fluidauslass 313 aus der Transportvorrichtung 300 ausströmen.

Die Querschnittsfläche des Diffusors ist an dem Ende des Diffusors, das dem Aktor 330 zugewandt ist, größer als die Querschnittsfläche des Endes des Diffusors 314, das dem Aktor 330 abgewandt ist.

Der erste Diffusor 312 des Fluideinlasses 311 kann gleich zu dem zweiten Diffusor 314 des Fluidauslasses 313 ausgestaltet sein.

Das Dichtelement 370 umfasst die Dichtbahn 377 und das Federelement 376. Ist eine Kavität 335 in dem Aktor 330 vorhanden (in einem Bereich des Federelements 376), drückt ein Abschnitt des Federelements 376 einen korrespondierenden Abschnitt der Dichtbahn 377 in Richtung der Kavität 335, sodass dieser Abschnitt der Dichtbahn 377 an dem Aktor 330 (Kavitätsfläche 331 des Aktors 330) anliegt und die Kavität 335 durch das Dichtelement 370 randseitig abgedichtet ist. Das Federelement 376 des Dichtelements 370 ragt aus der Nut 317, in der es angeordnet ist, in Richtung des Aktors 330 hinaus.

Bevorzugt ist die Dichtbahn 377 mit einem Abschnitt des Gehäuses 310, speziell mit dem ersten Gehäuseabschnitt 320, haftend verbunden. Dies beispielsweise über eine Verklebung oder eine stoffschlüssige Verbindung.

Die Dichtbahn 377 kann eine geöffnete Seite der Nut 317, in der das Federelement 376 angeordnet ist, überspannen oder verschließen. Speziell kann die Dichtbahn 377 eine geöffnete Seite der Nut vollständig überspannen oder verschließen.

In Figur 3d ist die Transportvorrichtung 300 in einer schematischen Draufsicht dargestellt, wobei die Nut 317 in dem Gehäuse 310 angedeutet ist. In der Nut 317 ist das Federelement 376 des Dichtelements 370 angeordnet.

Die Nut 317 mit dem Federelement 376 des Dichtelements 370 umschließt einen Bereich oder Flächenabschnitt des Gehäuses 310, insbesondere des ersten Gehäuseabschnitts 320, in dem das Fluid von dem Fluideinlass 311 über den angedeuteten Diffusor 312 zu dem Fluidauslass 313 über den angedeuteten Diffusor 314 transportiert werden kann. In Richtung einer Achse zwischen dem Fluideinlass 311 und dem Fluidauslass 313 ist die Kavität 335 durch das Dichtelement 370, insbesondere durch die Dichtbahn 377 des Dichtelements 370, endseitig abgedichtet und in Richtung einer weiteren Achse, die senkrecht zu der ersten Achse ist, ist die Kavität 335 durch das Dichtelement 370, insbesondere durch die Dichtbahn 377 des Dichtelements 370, randseitig abgedichtet. Durch diese Abdichtung wird eine Leckage von Fluid in einer Kavität 335 reduziert oder sogar vermieden und die hydraulische Leistung der Transportvorrichtung (Pumpe) verbessert.

Die Grundform der Nut 317 entspricht im Wesentlichen der Grundform des Aktors 330.

Das Federelement 376 des Dichtelements 370 kann eine rechteckringartige Form aufweisen, speziell mit abgerundeten Ecken. Das Federelement 376 kann durchgängig ausgestaltet sein, insbesondere über die gesamte Länge der Nut 317 in der Nut 317 angeordnet sein.

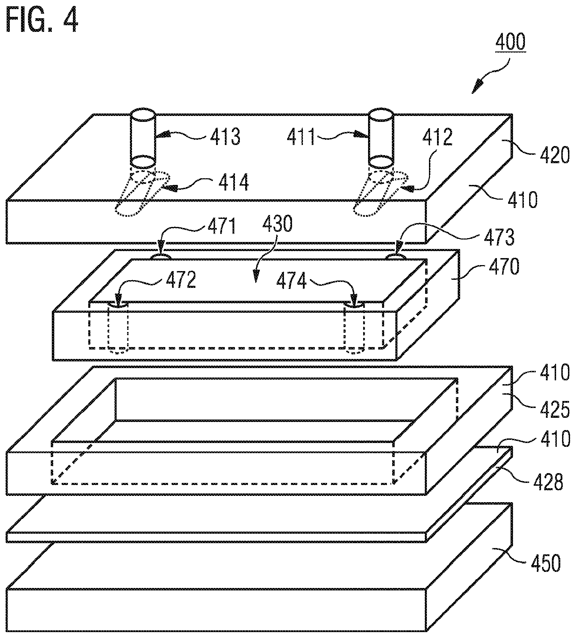

Figur 4 zeigt eine Transportvorrichtung 400 in einer Explosionsansicht. Die Transportvorrichtung 400 umfasst ein Gehäuse 410, einen Aktor 430, einen Antrieb 450 und ein Dichtelement 470.

Das Gehäuse ist aufgeteilt in drei Gehäuseabschnitte 420, 425, 428. Die drei Gehäuseabschnitte 420, 425, 428 sind gesonderte Elemente (Bauteile), die nicht stoffschlüssig miteinander verbunden sind. Zumindest zwei der drei Gehäuseabschnitte 420, 425, 428 können einstückig ausgebildet sein oder stoffschlüssig miteinander verbunden sein.

Der erste Gehäuseabschnitt 420 umfasst einen Fluideinlass 411 mit einem daran angeschlossenen Diffusor 412 (angedeutet in Figur 4) und einen Fluidauslass 413 mit einem verbundenen Diffusor 414 (angedeutet in Figur 4).

Der Aktor 430 ist quaderförmig ausgestaltet und rahmenartig, die Stirnflächen und Seitenflächen kontaktierend von dem Dichtelement 470 umgeben. Der zweite Gehäuseabschnitt 425 ist ausgestaltet das Dichtelement 470 mit dem umrahmten Aktor 430 zu umrahmen oder einzuschließen.

Das Dichtelement 470 weist vier Ausnehmungen 471, 472, 473, 474 auf, die sich über die gesamte Höhe des Dichtelements 470 erstrecken können. Zusammen mit dem Aktor 430 bilden die Ausnehmungen 471, 472, 473, 474 Kanäle, die eine Kavität der unteren Kavitätsfläche des Aktors 430 mit einer Kavität der oberen Kavitätsfläche des Aktors 430 verbinden, wenn sich die Kavitäten in einem passenden Bereich zu den Ausnehmungen 471, 472, 473, 474 befinden (nicht in Figur 4 dargestellt).

Der Fluideinlass 411 kann über den Diffusor 412 mit einer Kavität in der oberen Kavitätsfläche des Aktors 430 fluidkommunizierend verbunden sein. Ist eine Kavität der unteren Kavitätsfläche mit einer Kavität der oberen Kavitätsfläche des Aktors 430 fluidkommunizierend, z. B. über die Ausnehmungen 473, 474, verbunden, kann über den Fluideinlass 411 ein Fluid in beide Kavitäten einströmen.

Analog kann bei einer Verbindung der mit Fluid gefüllten Kavitäten, z. B. über die Ausnehmungen 471, 472, das Fluid aus dem Fluidauslass 413 über den Diffusor 414 aus der Vorrichtung ausströmen.

Der dritte Gehäuseabschnitt 428 ist vorzugsweise dünn (dünner als der erste Gehäuseabschnitt 420 oder der zweite Gehäuseabschnitt 425) ausgestaltet.

Der zweite Gehäuseabschnitt 425 ist zwischen dem ersten Gehäuseabschnitt 420 und dem dritten Gehäuseabschnitt 420 angeordnet.

Die drei Gehäuseabschnitte 420, 425, 428 können miteinander verklebt oder verschraubt sein.

Der Antrieb 450 ist analog zu den zuvor beschriebenen Antrieben.

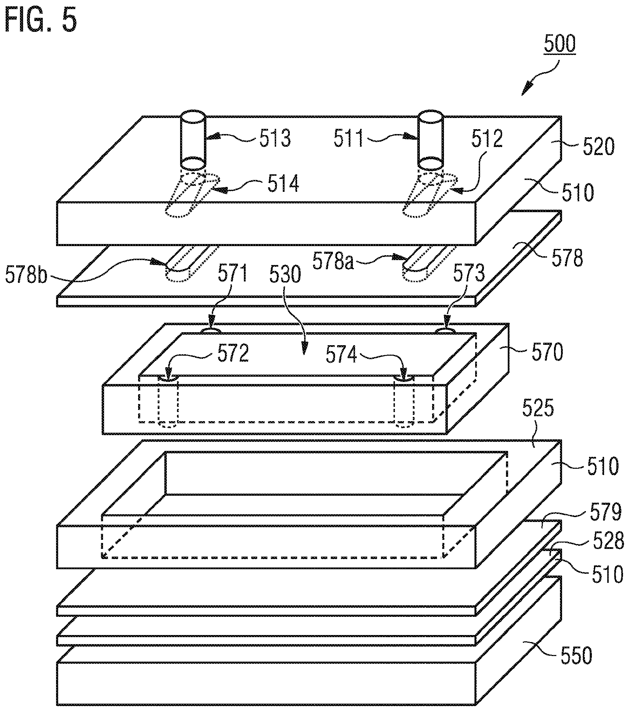

Figur 5 zeigt eine Transportvorrichtung 500 in einer Explosionsansicht. Die Transportvorrichtung 500 umfasst ein Gehäuse 510, einen Aktor 530, einen Antrieb 550 und ein Dichtelement 570.

Diese Komponenten der Transportvorrichtung sind gleich zu den gleichen Komponenten der Transportvorrichtung 400 ausgestaltet, sodass die Beschreibung dieser Komponenten mit Blick auf Figur 4 auch für die gleichen Komponenten der Transportvorrichtung 500 mit Blick auf Figur 5 zutrifft.

Zusätzlich umfasst die Transportvorrichtung 500 eine erste Dichtbahn 578 und eine zweite Dichtbahn 579. Die erste Dichtbahn 578 umfasst zwei Ausnehmungen 578a, 578b. Die Ausnehmungen 578a, 578b sind so geformt und so in der ersten Dichtbahn 578 positioniert, dass sie zu der Form der Enden der Diffusoren 512, 514, die dem Aktor 530 zugewandt sind, passend sind.

Die Ausnehmung 578a erlaubt ein Einströmen von Fluid über den Fluideinlass 511 und den Diffusor 512 in eine Kavität in der oberen Kavitätsfläche des Aktors 530 und über die Ausnehmungen 573, 574 in dem Dichtelement 570 ein Einströmen in die Kavität der unteren Kavitätsfläche des Aktors 530.

Analog erlaubt die Ausnehmung 578b ein Ausströmen von Fluid der Kavität in der oberen Kavitätsfläche des Aktors 530 und, über die Ausnehmungen 571, 572 in dem Dichtelement 570, ein Ausströmen von Fluid aus der Kavität in der unteren Kavitätsfläche des Aktors 530 über den Diffusor 514 und den Fluidauslass 513.

Die erste Dichtbahn 578 kann zwischen dem ersten Gehäuseabschnitt 520 und dem zweiten Gehäuseabschnitt 525 angeordnet sein, insbesondere so, dass der erste Gehäuseabschnitt 520 nicht den Aktor 530 direkt kontaktiert. Zusätzlich gewährleistet die erste Dichtbahn 578 eine Abdichtung einer Kavität in der oberen Kavitätsfläche des Aktors 530. Die zweite Dichtbahn 579 kann zwischen dem zweiten Gehäuseabschnitt 525 und dem dritten Gehäuseabschnitt 528 angeordnet sein. Dadurch kann der Aktor 530 den dritten Gehäuseabschnitt 528 nicht direkt kontaktieren und eine Abdichtung einer Kavität in der unteren Kavitätsfläche des Aktors 530 ist gewährleistet.

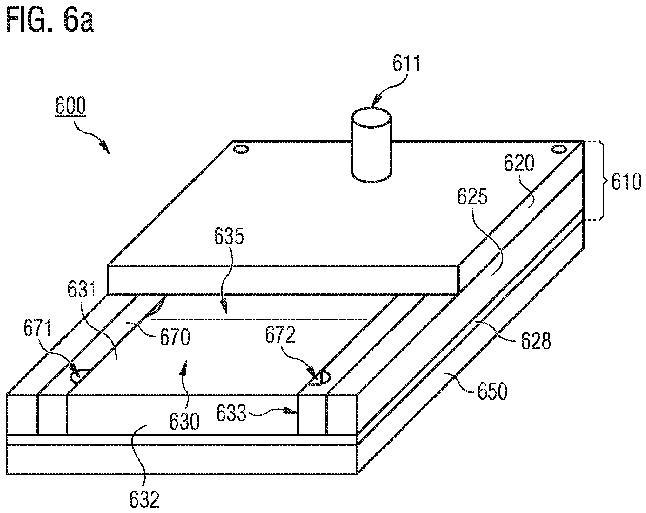

Die Figuren 6a bis 6d zeigen eine Ausführungsform einer Transportvorrichtung 600. Bei der Transportvorrichtung 600 handelt es sich speziell um eine Pumpe, noch spezieller um eine Mikropumpe.

In Figur 6a ist die Transportvorrichtung 600 perspektivisch und schematisch dargestellt, wobei Ausbrüche dargestellt sind.

Die Transportvorrichtung 600 umfasst ein Gehäuse 610, einen Aktor 630, einen Antrieb 650 und ein Dichtelement 670. Der Aktor 630 umfasst eine magnetische Formgedächtnislegierung. Durch ein Magnetfeld, bereitgestellt durch den Antrieb 650, kann der Aktor in seiner Form verändert werden. Der Aktor 630 kann aus der magnetischen Formgedächtnislegierung bestehen.

Die Grundform des Aktors 630 ist im Wesentlichen quaderförmig. Der Aktor 630 umfasst zwei Seitenflächen, zwei Stirnflächen und zwei Kavitätsflächen, wobei in den Kavitätsflächen Kavitäten 635, 635' (in Figur 6a nur eine Kavität 635 dargestellt) ausgebildet werden sollen.

Die Flächen der Kavitätsflächen sind größer als die Flächen der Stirnflächen und der Seitenflächen. Insbesondere können die Flächen der Kavitätsflächen um mindestens den Faktor 3 größer sein als die Flächen der Stirnflächen oder der Seitenflächen des Aktors 630.

In der Kavitätsfläche 631 ist eine Kavität 635 gebildet, die zwischen den Seitenflächen des Aktors 630 verläuft. Die Kavität 635 (und auch die Kavität 635') ist zwischen den Stirnflächen abschnittsweise in dem Aktors 630 ausgebildet.

Das Gehäuse 610 umfasst einen ersten Gehäuseabschnitt 620, einen zweiten Gehäuseabschnitt 625 und einen dritten Gehäuseabschnitt 628. Die Gehäuseabschnitte 620, 625, 628 sind nicht stoffschlüssig verbunden, können jedoch durch eine Verschraubung oder eine Verklebung miteinander verbunden sein. Auch eine einstückige Ausgestaltung von zumindest zwei der Gehäuseabschnitte 620, 625, 628 ist möglich.

Das Gehäuse 610 umfasst einen Fluideinlass 611, der insbesondere in dem ersten Gehäuseabschnitt 620 des Gehäuses 610 angeordnet ist. Der dritte Gehäuseabschnitt 628 ist dünner als der erste Gehäuseabschnitt 620 und/oder der zweite Gehäuseabschnitt 625. Der Aktor 630 ist in dem Gehäuse 610 angeordnet. Der Aktor 630 kann so in dem Gehäuse 610 angeordnet sein, dass alle Flächen des Aktors 630, das heißt Kavitätsflächen 631, Stirnflächen 632, Seitenflächen 633, vollständig von dem Gehäuse umschlossen sind.

Das Dichtelement 670 weist Ausnehmungen 671, 672, 673, 674 auf (Ausnehmungen 673 und 674 in Figur 6a nicht dargestellt). Zusammen mit den Seitenflächen des Aktors 630 bilden die Ausnehmungen 671, 672, 673, 674 je einen Kanal. Befindet sich eine Kavität 635 in der Nähe der Ausnehmungen 671, 672 und eine weitere Kavität 635' auf der Fläche des Aktors 630, die der Fläche mit der Kavität 635 gegenüberliegt, sind die Kavitäten 635, 635' über die Ausnehmungen 671, 672 fluidkommunizierend verbunden.

Die Transportvorrichtung 600 kann Dichtbahnen 578, 579 wie mit Blick auf Figur 5 beschrieben umfassen.

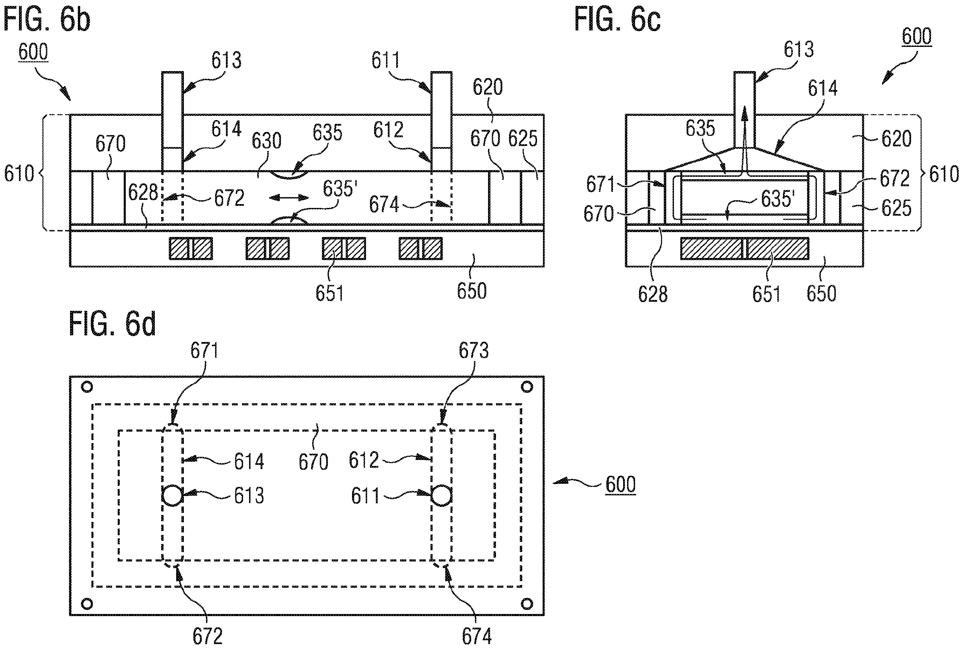

In Figur 6b ist eine Transportvorrichtung 600 in einer schematischen Vorderansicht dargestellt. Die Transportvorrichtung 600 umfasst ein Gehäuse 610 mit einem ersten Gehäuseabschnitt 620, einem zweiten Gehäuseabschnitt 625 und einem dritten Gehäuseabschnitt 628. Die Transportvorrichtung 600 umfasst weiterhin einen Aktor 630, einen Antrieb 650 mit mehreren Magneten 651 und ein Dichtelement 670.

Das Gehäuse 610 umfasst einen Fluideinlass 611 und einen Diffusor 612 sowie einen Fluidauslass 613 mit verbundenem Diffusor 614. Das Dichtelement 670 umschließt den Aktor 630 in einer Ebene, insbesondere in der Ebene der Bewegung einer Kavität 635, 635' in dem Aktor 630. Dabei kontaktiert das Dichtelement 670 die Stirnseiten und die Seitenflächen des Aktors 630.

Die Ausnehmung 672 und 674 (in Figur 6b angedeutet) sind im Wesentlichen mit dem Fluideinlass 611 (Diffusor 612) fluchtend oder mit dem Auslass 613 (Diffusor 614) fluchtend. Dadurch wird ermöglicht, dass, wenn sich die Kavitäten 635, 635' an eine Position bewegt haben, die eine Fluidkommunikation der Kavität 635 mit dem Diffusor 614 und dem Fluidauslass 613 ermöglicht, auch eine Fluidkommunikation der Kavität 635 mit der Kavität 635' gewährleistet ist, sodass Fluid aus beiden Kavitäten 635, 635' aus dem Fluidauslass 613 ausströmen kann. Analog wird ein Einströmen von Fluid in die Kavitäten 635, 635' über den Fluideinlass 611 und dem Diffusor 612 gewährleistet.

In Figur 6c ist die Transportvorrichtung 600 in einer schematischen Seitenansicht dargestellt, wobei in dieser Ansicht eine Fluidkommunikation zwischen der Kavität 635', der Ausnehmung 671, der Ausnehmung 672, der Kavität 635, dem Diffusor 614 und dem Fluidauslass 613 gezeigt ist.

Das Dichtelement 670 umläuft den Aktor 630 an dessen Seitenflächen (vollständig).

Die Transportvorrichtung 600 ist in Figur 6d in einer schematischen Draufsicht gezeigt. Der Fluideinlass 611 ist mit einem Diffusor 612 verbunden. Mit dem Diffusor 612 fluchten die Ausnehmungen 673, 674.

Der Fluidauslass 613 ist mit dem Diffusor 614 verbunden. Die Ausnehmungen 671, 672 fluchten mit dem Diffusor 614.

Das Dichtelement 670 umschließt den Aktor 630 (in einer Ebene) vollständig. Ebenso werden die Diffusoren 614, 612 von dem projizierten Dichtelement 670 eingeschlossen.

Das Dichtelement 670 kann eine rechteckringartige Form aufweisen.

Die Flächen oder die Fläche des Gehäuses 610, die mit einem Fluid in einer der Kavitäten 635, 635' in Kontakt geraten kann, ist oder sind bevorzugt beschichtet, insbesondere mit einer PTFE-Beschichtung.

Speziell kann die Fläche des ersten Gehäuseabschnitts 620, die dem Aktor 630 zugewandt ist, mit einer solchen Beschichtung versehen sein.

Auch kann die Fläche des dritten Gehäuseabschnitts 628, die dem Aktor 630 zugewandt ist, mit einer solchen Beschichtung versehen sein.

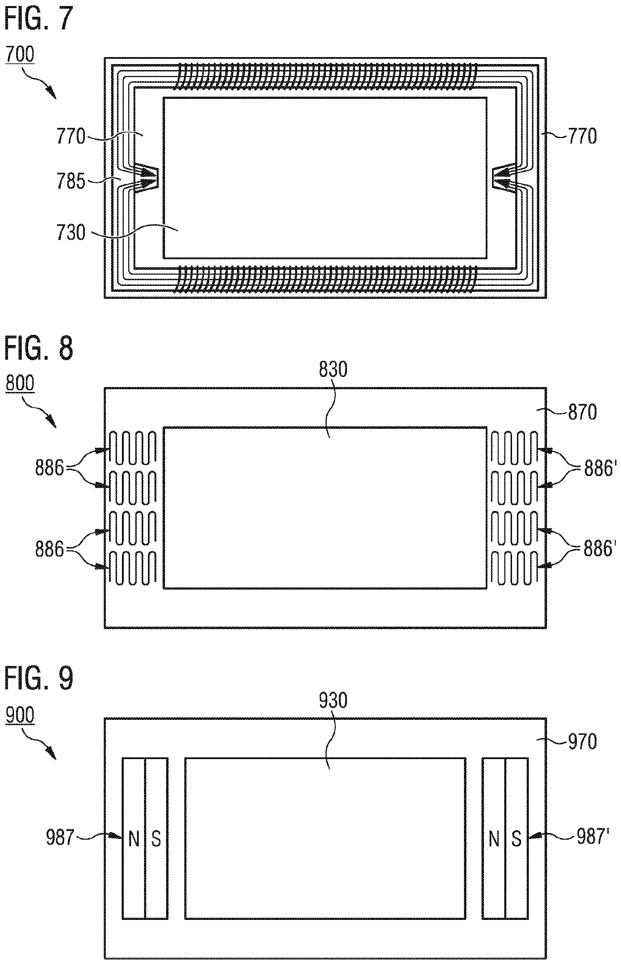

Figur 7 zeigt einen Aktor 730 und ein Dichtelement 770, wobei das Dichtelement 770 den Aktor einschließt (umläuft).

In dem Dichtelement 770 ist ein Rückstellelement 785 angeordnet. Das Rückstellelement 785 ist als Elektromagnet ausgestaltet.

Das Rückstellelement 785 dient der (magnetischen) Rückstellung des Aktors 730 nach einer Bildung von Kavitäten in dem Aktor 730, wie oben beschrieben.

In Figur 8 ist schematisch eine Transportvorrichtung 800 mit einem Aktor 830 und einem Dichtelement 870 dargestellt. Das Dichtelement 870 umfasst zwei Rückstellelemente 886, 886'. Die Rückstellelemente 886, 886' sind in dem Dichtelement 870 angeordnet und umfassen je mehrere Federn, wobei je ein Rückstellelement 886, 886' auf gegenüberliegenden Seiten des Aktors 830 in dem Dichtelement 870 angeordnet ist. Durch die Federn 886, 886' wird eine mechanische Rückstellung des Aktors 830, wie oben beschrieben, gewährleistet.

Die Federn 886, 886' können Metallfedern oder Kunststofffedern sein.

In einer Draufsicht (schematisch) zeigt Figur 9 eine Transportvorrichtung 900 mit einem Aktor 930 und einem Dichtelement 970. In dem Dichtelement 970 sind zwei Rückstellelemente 987, 987' angeordnet. Die Rückstellelemente 987, 987' umfassen je einen Permanentmagnet, wobei je ein Rückstellelement 886, 886' auf gegenüberliegenden Seiten des Aktors 930 in dem Dichtelement 970 angeordnet ist. Durch die Permanentmagnete 987, 987' wird eine magnetische Rückstellung des Aktors 930, wie oben beschrieben, ermöglicht.

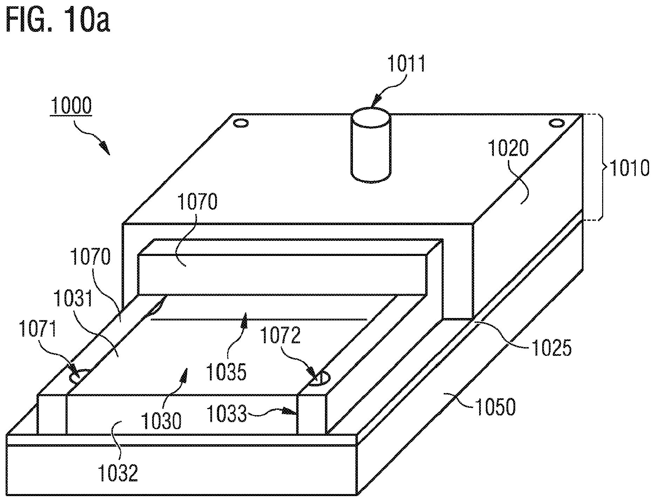

Die Figuren 10a bis 10d zeigen eine Ausführungsform einer Transportvorrichtung 1000. Die Transportvorrichtung 1000 kann eine Pumpe, speziell eine Mikropumpe, sein.

In Figur 10a ist die Transportvorrichtung 1000 perspektivisch und schematisch mit Ausbrüchen dargestellt.

Die Transportvorrichtung 1000 umfasst ein Gehäuse 1010, einen Aktor 1030, einen Antrieb 1050 und ein Dichtelement 1070.

Der Aktor 1030 umfasst eine magnetische Formgedächtnislegierung. Durch ein Magnetfeld, bereitgestellt durch den Antrieb 1050, kann der Aktor in seiner Form verändert werden. Der Aktor 1030 kann aus der magnetischen Formgedächtnislegierung bestehen.

Die Grundform des Aktors 1030 ist im Wesentlichen quaderförmig. Der Aktor 1030 umfasst zwei Seitenflächen, zwei Stirnflächen und zwei Kavitätsflächen, wobei in den Kavitätsflächen Kavitäten 1035, 1035' (in Figur 10a nur eine Kavität 1035 dargestellt) ausgebildet werden sollen.

Die Flächen der Kavitätsflächen sind größer als die Flächen der Stirnflächen und der Seitenflächen. Insbesondere können die Flächen der Kavitätsflächen um mindestens den Faktor 3 größer sein als die Flächen der Stirnflächen oder der Seitenflächen des Aktors 1030.

In der Kavitätsfläche 1031 ist eine Kavität 1035 gebildet, die zwischen den Seitenflächen des Aktors 1030 verläuft. Die Kavität 1035 (und auch die Kavität 1035') ist zwischen den Stirnflächen 1032 abschnittsweise in dem Aktors 1030 ausgebildet.

Das Gehäuse 1010 umfasst einen ersten Gehäuseabschnitt 1020 und einen zweiten Gehäuseabschnitt 1025. Die Gehäuseabschnitte 1020, 1025 sind nicht stoffschlüssig verbunden, können jedoch durch eine Verschraubung oder eine Verklebung miteinander verbunden sein.

Das Gehäuse 1010 umfasst einen Fluideinlass 1011, der insbesondere in dem ersten Gehäuseabschnitt 1020 des Gehäuses 1010 angeordnet ist. Der zweite Gehäuseabschnitt 1025 ist dünner als der erste Gehäuseabschnitt 1020. Der Aktor 1030 ist in dem Gehäuse 1010 angeordnet. Der Aktor 1030 kann so in dem Gehäuse 1010 angeordnet sein, dass alle Flächen des Aktors 1030, also Kavitätsflächen 1031, Stirnflächen 1032, Seitenflächen 1033, vollständig von dem Gehäuse 1030 umschlossen sind.

Das Dichtelement 1070 weist Ausnehmungen 1071, 1072, 1073, 1074 auf (Ausnehmungen 1073 und 1074 in Figur 10a nicht dargestellt). Zusammen mit den Seitenflächen des Aktors 1030 bilden die Ausnehmungen 1071, 1072, 1073, 1074 je einen Kanal. Befindet sich eine Kavität 1035 in der Nähe der Ausnehmungen 1071, 1072 und eine weitere Kavität 1035' auf der Fläche des Aktors 1030, die der Fläche mit der Kavität 1035 gegenüberliegt, sind die Kavitäten 1035, 1035' über die Ausnehmungen 1071, 1072 fluidkommunizierend verbunden.

Die Transportvorrichtung 1000 kann eine Dichtbahn 579 wie mit Blick auf Figur 5 beschrieben umfassen. Die Dichtbahn 579 kann zwischen dem ersten Gehäuseabschnitt 1020 und dem zweiten Gehäuseabschnitt 1025 angeordnet sein.

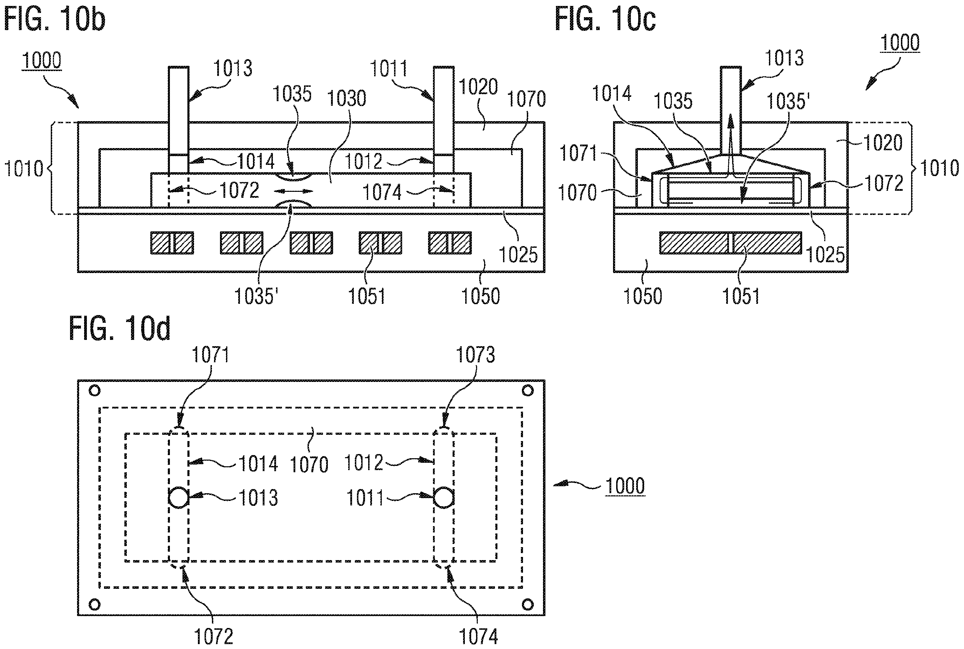

In Figur 10b ist eine Transportvorrichtung 1000 in einer schematischen Vorderansicht dargestellt. Die Transportvorrichtung 1000 umfasst ein Gehäuse 1010 mit einem ersten Gehäuseabschnitt 1020 und einem zweiten Gehäuseabschnitt 1025. Die Transportvorrichtung 1000 umfasst weiterhin einen Aktor 1030, einen Antrieb 1050 mit mehreren Magneten 1051 und ein Dichtelement 1070.

Das Gehäuse 1010 umfasst einen Fluideinlass 1011 und einen Diffusor 1012 sowie einen Fluidauslass 1013 mit verbundenem Diffusor 1014.

Das Dichtelement 1070 umschließt den Aktor 1030 in einer Ebene, insbesondere in der Ebene der Bewegung einer Kavität 1035, 1035' in dem Aktor 1030. Zusätzlich umgibt das Dichtelement 1070 eine der Kavitätsflächen 1031 des Aktors 1070, insbesondere die Kavitätsfläche, die dem Fluideinlass 1011 und/oder Fluidauslass 1013 zugewandt ist.

Das Dichtelement 1070 kann mindestens fünf der sechs Seiten des Aktors 1030 zumindest abschnittsweise kontaktieren, sh. hierzu auch Figuren 10a und 10c.

Ein Abschnitt des Fluideinlasses 1011 und/oder ein Abschnitt des Fluidauslasses 1013 sind von dem Dichtelement 1070 umgeben. Auch der Diffusor 1012 des Fluideinlasses 1011 und/oder der Diffusor 1014 des Fluidauslasses 1013 können abschnittsweise von dem Dichtelement 1070 umgeben sein.

Die Ausnehmung 1072 und 1074 (in Figur 10b angedeutet) sind im Wesentlichen mit dem Fluideinlass 1011 (Diffusor 1012) fluchtend oder mit dem Auslass 1013 (Diffusor 1014) fluchtend. Dadurch wird ermöglicht, dass, wenn sich die Kavitäten 1035, 1035' an eine Position bewegt haben, die eine Fluidkommunikation der Kavität 1035 mit dem Diffusor 1014 und dem Fluidauslass 1013 ermöglicht, auch eine Fluidkommunikation der Kavität 1035 mit der Kavität 1035' gewährleistet ist, sodass Fluid aus beiden Kavitäten 1035, 1035' aus dem Fluidauslass 1013 ausströmen kann. Analog wird ein Einströmen von Fluid in die Kavitäten 1035, 1035' über den Fluideinlass 1011 und dem Diffusor 1012 gewährleistet.

In Figur 10c ist die Transportvorrichtung 1000 in einer schematischen Seitenansicht dargestellt, wobei in dieser Ansicht eine Fluidkommunikation zwischen der Kavität 1035', der Ausnehmung 1071, der Ausnehmung 1072, der Kavität 1035, dem Diffusor 1014 und dem Fluidauslass 1013 gezeigt ist.

Das Dichtelement 1070 umläuft den Aktor 1030 an dessen Seitenflächen (vollständig) und umschließt die Kavitätsfläche 1031 des Aktors 1030, die dem Fluideinlass 1011 und/oder dem Fluidauslass 1013 zugewandt ist. Bevorzugt kontaktiert das Dichtelement 1070 die Kavitätsfläche des Aktors 1030, die dem Antrieb 1050 zugewandt ist, (im Wesentlichen) nicht.

Die Transportvorrichtung 1000 ist in Figur 10d in einer schematischen Draufsicht gezeigt. Der Fluideinlass 1011 ist mit einem Diffusor 1012 verbunden. Mit dem Diffusor 1012 fluchten die Ausnehmungen 1073, 1074.

Der Fluidauslass 1013 ist mit dem Diffusor 1014 verbunden. Die Ausnehmungen 1071, 1072 fluchten mit dem Diffusor 1014.

Das Dichtelement 1070 umschließt den Aktor 1030 (in einer Ebene) vollständig. Ebenso werden die Diffusoren 1014, 1012 von dem projizierten Dichtelement 1070 eingeschlossen.

Die Flächen oder die Fläche des Gehäuses 1010, die mit einem Fluid in einer der Kavitäten 1035, 1035' in Kontakt geraten kann, ist oder sind bevorzugt beschichtet, insbesondere mit einer PTFE-Beschichtung.

Speziell kann die Fläche des ersten Gehäuseabschnitts 1020, die dem Aktor 1030 zugewandt ist, mit einer solchen Beschichtung versehen sein.

Auch kann die Fläche des dritten Gehäuseabschnitts 1028, die dem Aktor 1030 zugewandt ist, mit einer solchen Beschichtung versehen sein.

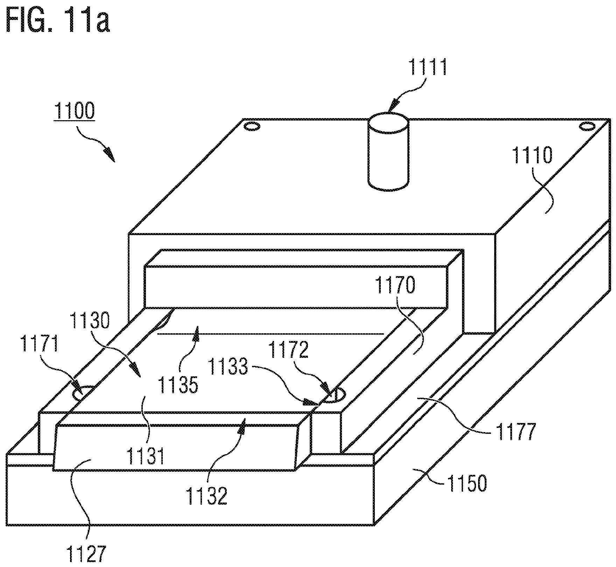

Die Figuren 11a bis 11d zeigen eine Ausführungsform einer Transportvorrichtung 1100. Bei der Transportvorrichtung 1100 handelt es sich speziell um eine Pumpe, noch spezieller um eine Mikropumpe.

In Figur 11a ist die Transportvorrichtung 1100 perspektivisch und schematisch dargestellt, wobei Ausbrüche dargestellt sind.

Die Transportvorrichtung 1100 umfasst ein Gehäuse 1110, einen Aktor 1130, einen Antrieb 1150 und ein Dichtelement 1170. Der Aktor 1130 umfasst eine magnetische Formgedächtnislegierung. Durch ein Magnetfeld, bereitgestellt durch den Antrieb 1150, kann der Aktor in seiner Form verändert werden. Der Aktor 1130 kann aus der magnetischen Formgedächtnislegierung bestehen.

Der Aktor 1130 ist im Wesentlichen quaderförmig ausgestaltet. Der Aktor 1130 umfasst zwei Seitenflächen, zwei Stirnflächen und zwei Kavitätsflächen, wobei in den Kavitätsflächen Kavitäten 1135, 1135' (in Figur 11a nur eine Kavität 1135 dargestellt) ausgebildet werden sollen.

Die Flächen der Kavitätsflächen sind größer als die Flächen der Stirnflächen und der Seitenflächen. Insbesondere können die Flächen der Kavitätsflächen um mindestens den Faktor 3 größer sein als die Flächen der Stirnflächen oder der Seitenflächen des Aktors 1130.

In der Kavitätsfläche 1131 ist eine Kavität 1135 gebildet, die zwischen den Seitenflächen des Aktors 1130 verläuft. Die Kavität 1135 (und auch die Kavität 1135') ist zwischen den Stirnflächen abschnittsweise in dem Aktors 1130 ausgebildet.

Das Gehäuse 1110 umfasst einen Fluideinlass 1111 und einen Fluidauslass 1113. Der Aktor 1130 kann so in dem Gehäuse 1110 angeordnet sein, dass die Stirnflächen 1132, Seitenflächen 1133 und zumindest eine der Kavitätsflächen 1131 von dem Gehäuse 1110 umschlossen sind.

Das Dichtelement 1170 weist Ausnehmungen 1171, 1172, 1173, 1174 auf (Ausnehmungen 1173 und 1174 in Figur 11a nicht dargestellt). Zusammen mit den Seitenflächen des Aktors 1130 bilden die Ausnehmungen 1171, 1172, 1173, 1174 je einen Kanal. Befindet sich eine Kavität 1135 in der Nähe der Ausnehmungen 1171, 1172 und eine weitere Kavität 1135' auf der Fläche des Aktors 1130, die der Fläche mit der Kavität 1135 gegenüberliegt, sind die Kavitäten 1135, 1135' über die Ausnehmungen 1171, 1172 fluidkommunizierend verbunden.

Die Transportvorrichtung 1100 umfasst eine Dichtbahn 1177, die zwischen dem Aktor 1130 und dem Antrieb 1150 angeordnet ist.

Die Transportvorrichtung 1100 umfasst zwei Einspannelementen 1126, 1127, wobei je eines der Einspannelemente 1126, 1127 eine Seite des Aktors 1130, insbesondere eine Stirnfläche 1132, kontaktiert. Die Einspannelemente 1126, 1127 können sich über die gesamte Länge der jeweils kontaktierten Seite oder Fläche des Aktors 1130 erstrecken.

Die Einspannelemente 1126, 1127 weisen eine trapezförmige Grundform auf. Zumindest eine Seite der Einspannelemente 1126, 1127 ist jeweils trapezförmig ausgestaltet.

Die Einspannelemente 1126, 1127 können das Dichtelement 1170, das Gehäuse 1110, den Aktor 1130 und/oder die Dichtbahn 1177 kontaktieren.

Die Einspannelemente 1126, 1127 können aus einem nicht kompressiblen Material bestehen.

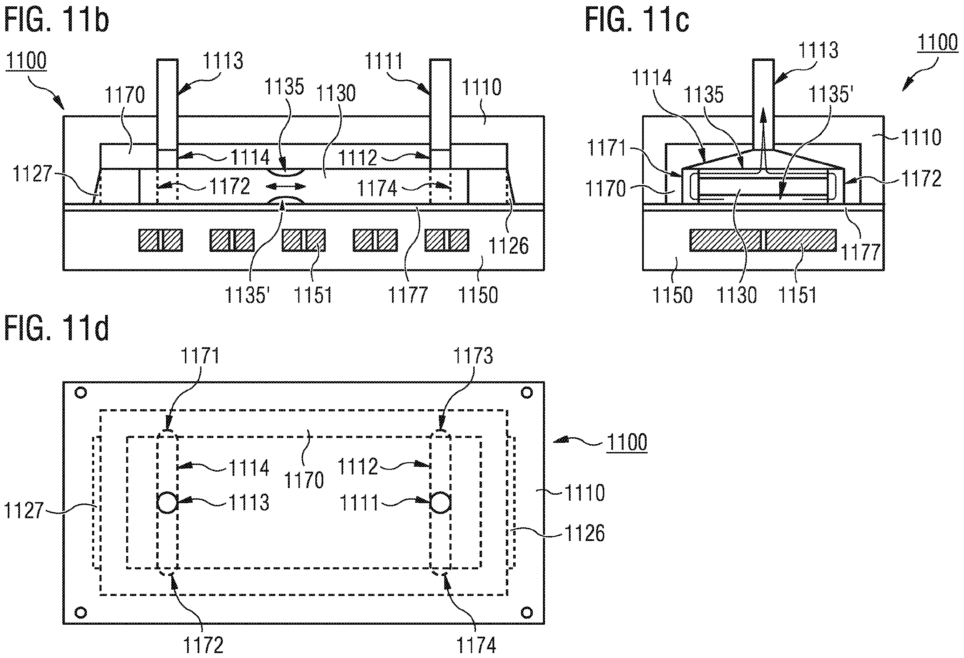

In Figur 11b ist eine Transportvorrichtung 1100 in einer schematischen Vorderansicht dargestellt. Die Transportvorrichtung 1100 umfasst ein Gehäuse 1110, einen Aktor 1130, einen Antrieb 1150 mit mehreren Magneten 1151 und ein Dichtelement 1170.

Das Gehäuse 1110 umfasst einen Fluideinlass 1111 und einen Diffusor 1112 sowie einen Fluidauslass 1113 mit verbundenem Diffusor 1114. Das Dichtelement 1170 umgreift eine der Kavitätsflächen 1131 und zumindest eine der Seitenflächen 1133, speziell beide Seitenflächen 1133.

Die Ausnehmung 1172 und 1174 (in Figur 11b angedeutet) sind im Wesentlichen mit dem Fluideinlass 1111 (Diffusor 1112) fluchtend oder mit dem Auslass 1113 (Diffusor 1114) fluchtend. Dadurch wird ermöglicht, dass, wenn sich die Kavitäten 1135, 1135' an eine Position bewegt haben, die eine Fluidkommunikation der Kavität 1135 mit dem Diffusor 1114 und dem Fluidauslass 1113 ermöglicht, auch eine Fluidkommunikation der Kavität 1135 mit der Kavität 1135' gewährleistet ist, sodass Fluid aus beiden Kavitäten 1135, 1135' aus dem Fluidauslass 1113 ausströmen kann. Analog wird ein Einströmen von Fluid in die Kavitäten 1135, 1135' über den Fluideinlass 1111 und dem Diffusor 1112 gewährleistet.

Je eines der Einspannelemente 1126, 1127 kontaktiert je eine der Stirnflächen des Aktors 1130.

In Figur 11c ist die Transportvorrichtung 1100 in einer schematischen Seitenansicht dargestellt, wobei in dieser Ansicht eine Fluidkommunikation zwischen der Kavität 1135', der Ausnehmung 1171, der Ausnehmung 1172, der Kavität 1135, dem Diffusor 1114 und dem Fluidauslass 1113 gezeigt ist.

Die Transportvorrichtung 1100 ist in Figur 11d in einer schematischen Draufsicht gezeigt. Der Fluideinlass 1111 ist mit einem Diffusor 1112 verbunden. Mit dem Diffusor 1112 fluchten die Ausnehmungen 1173, 1174.

Der Fluidauslass 1113 ist mit dem Diffusor 1114 verbunden. Die Ausnehmungen 1171, 1172 fluchten mit dem Diffusor 1114.

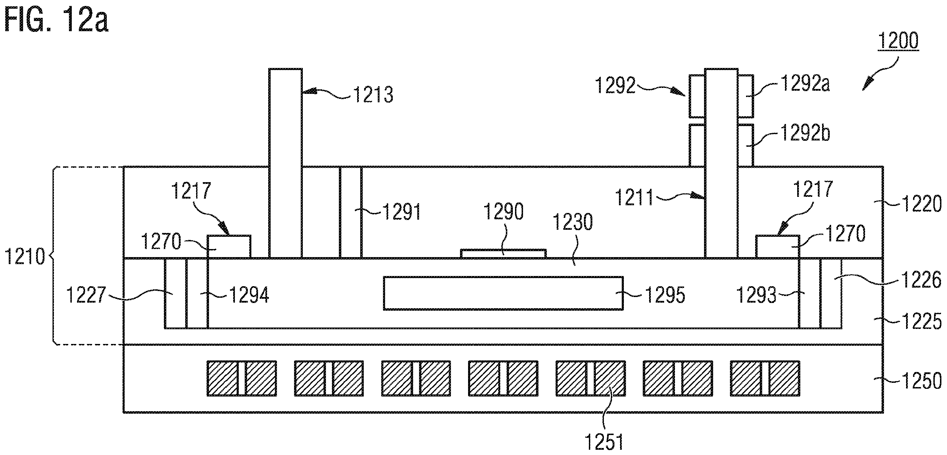

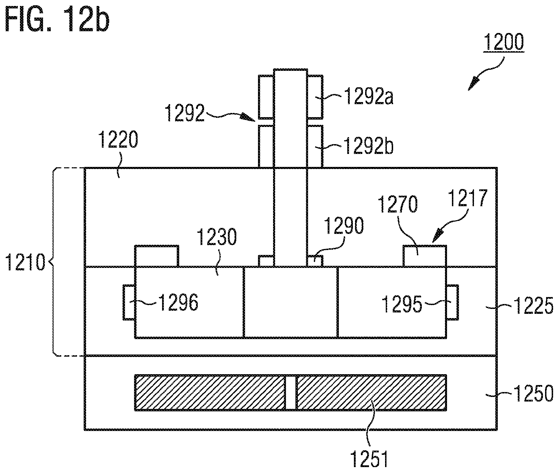

Exemplarisch sind in den Figuren 12a und 12b eine Transportvorrichtung 1200 mit Sensoren 1290, 1291, 1292, 1293, 1294, 1295, 1296 gezeigt.

Die mit Blick auf die Transportvorrichtung 1200 beschriebenen Merkmale der Sensoranordnung 1290,... sind in jeder der hierin beschriebenen Transportvorrichtungen 100,... integrierbar.

Die Transportvorrichtung 1200 umfasst ein Gehäuse 1210, das insbesondere einen ersten Gehäuseabschnitt 1220 und einen zweiten Gehäuseabschnitt 1225 umfasst. Zusätzlich umfasst die Transportvorrichtung 1200 einen Aktor 1230, einen Antrieb 1250, insbesondere mit mehreren Magneten 1251, und ein Dichtelement 1270, das speziell in einer Nut 1217 des Gehäuses 1210 angeordnet ist.

Die Sensoranordnung der Transportvorrichtung 1200 umfasst einen optischen Sensor 1291. Der optische Sensor 1291 ist in dem Gehäuse 1210 angeordnet und führt durch dieses hindurch. Ein Ende des optischen Sensors 1291 ist so in dem Gehäuse angeordnet, dass eine Fläche (speziell Kavitätsfläche) des Aktors 1230 optisch von dem Sensor 1291 erfassbar ist.

Dieses Ende kann ein Ende eines Lichtleiters sein, auf dessen anderen Ende eine Auswerteeinheit oder Analyseeinheit des optischen Sensors 1291 angeordnet ist.

Durch den optischen Sensor 1291 ist eine Fläche (Kavitätsfläche) des Aktors optisch vermessbar. Speziell kann eine Kavität in dem Aktor 1230 durch den optischen Sensor 1291 erfasst werden. Dies hinsichtlich der geometrischen Eigenschaften der Kavität in dem Aktor 1230 und hinsichtlich der Häufigkeit des Auftretens von Kavitäten in dem Aktor 1230.

Die Sensoranordnung der Transportvorrichtung 1200 kann auch einen Drucksensor 1292 umfassen. Der Drucksensor 1292 ist zumindest teilweise an dem Fluideinlass 1211 angeordnet und kann den absoluten Druck in dem Fluideinlass 1211 messen.

Bildet sich eine Kavität in dem Aktor 1230, die fluidkommunizierend mit dem Fluideinlass 1211 ist, entsteht ein Unterdruck, wodurch ein Fluid über den Fluideinlass 1211 in die Kavität des Aktors 1230 einströmen kann. Durch den Drucksensor 1292 ist dieser Druck in dem Fluideinlass 1211 messbar.

Der Drucksensor 1292 (auch Differenzdrucksensor) kann einen ersten Drucksensor 1292a und einen zweiten Drucksensor 1292b umfassen, sodass ein Differenzdruck zwischen dem Fluideinlass 1211 und dem Fluidauslass 1213 bestimmt werden kann. Dazu können zwei Drucksensoren 1292a, 1292b vor dem Fluideinlass 1211 oder zwei Drucksensoren nach dem Fluidauslass 1213 angeordnet sein (nicht vollständig in den Figuren 12a und 12b dargestellt).

Durch die Daten des Drucksensors 1292 lässt sich der Betrieb der Transportvorrichtung 1200 überwachen und auf Grundlage der Daten des Drucksensors 1292 kann der Betrieb der Transportvorrichtung 1200 gesteuert oder geregelt werden.

Ein Temperatursensor 1290 ist in der Transportvorrichtung 1200 so angeordnet, dass durch den Temperatursensor 1290 die Temperatur des Aktors 1230 erfasst werden kann. Insbesondere ist der Temperatursensor 1290 (teilweise) in dem Gehäuse 1210 der Transportvorrichtung 1200 angeordnet. Der Temperatursensor 1290 kann eine Fläche des Aktors 1230 kontaktieren.

Die Daten des Temperatursensors 1290 können verwendet werden, um den Betrieb der Transportvorrichtung 1200 zu überwachen, zu steuern oder zu regeln.

Insbesondere wird der Betrieb der Transportvorrichtung 1200 so angepasst (gesteuert oder geregelt), dass die Temperatur des Aktors 1230 einen Wert von 100 °C nicht überschreitet, speziell eine Temperatur von 55 °C nicht überschreitet. Die Temperatur des Aktors 1230 kann beispielsweise über ein (nicht in den Figuren 12a und 12b dargestelltes) Heiz- und/oder Kühlelement, z. B. Peltier-Element, angepasst werden.

Piezosensoren 1293, 1294 können eine Dehnung des Aktors 1230 (Kraftauswirkung des Aktors 1230) in Richtung von Kavitätsbewegungen zwischen dem Fluideinlass 1211 und dem Fluidauslass 1213 erfassen. Piezosensoren 1293, 1294 können an Stirnflächen des Aktors 1230 angeordnet sein. Ein Piezosensor 1293, 1294 an einer Stirnfläche des Aktors 1230 kann vorgesehen sein.

Die Piezosensoren 1293, 1294 können je eine Stirnfläche des Aktors 1230 kontaktieren und insbesondere je ein Einspannelement 1226, 1227 kontaktieren.

Die Daten der Piezosensoren 1293, 1294 können verwendet werden, um den Betrieb der Transportvorrichtung 1200 zu überwachen, zu steuern oder zu regeln. Durch die Größe und/oder Frequenz des von den Piezosensoren gemessenen Wertes kann auf den von der Transportvorrichtung 1200 transportierten Volumenstrom und/oder eine Alterung des Aktors 1230 geschlossen werden.

Durch Dehnmessstreifen 1295, 1296 lässt sich ebenso auf den von der Transportvorrichtung 1200 geförderten Volumenstrom und/oder die Alterung des Aktors 1230 schließen. Dehnmessstreifen 1295, 1296 können in dem Gehäuse 1210 angeordnet sein. Dabei können die Dehnmessstreifen 1295, 1296 je eine Seitenfläche des Aktors 1230 kontaktieren. Auch kann ein Dehnmessstreifen 1295, 1296 an einer Seitenfläche des Aktors 1230 angeordnet sein und diesen kontaktieren.

Daten der Dehnmessstreifen 1295, 1296 erlauben eine Überwachung, ein Steuern oder ein Regeln des Betriebs der Transportvorrichtung 1200.

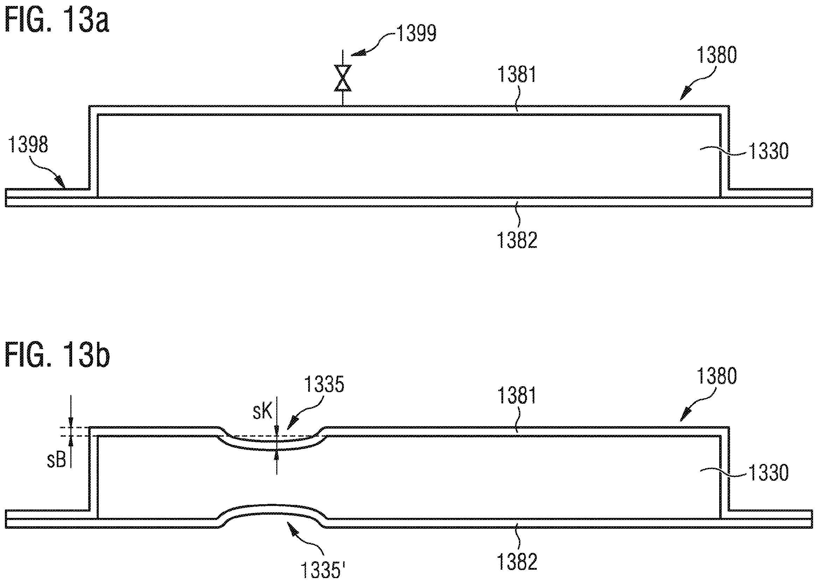

Die Figuren 13a und 13b zeigen einen Aktor 1330 mit einer Trennschicht 1380.

Jeder der hierin beschriebenen Aktoren 130, ..., 1330 kann eine Trennschicht 1380 umfassen.

In Figur 13a ist keine Kavität in dem Aktor 1330 ausgebildet. Die Trennschicht 1380 umschließt alle Seiten des Aktors 1330, wobei ebenso zumindest eine Seite des Aktors 1330 von der Trennschicht 1380 umschlossen sein kann.

Die Trennschicht 1380 umfasst ein erstes Folienelement 1381 und ein zweites Folienelement 1382. Die Folienelemente 1381, 1382 sind durch eine Verschweißung 1398 luftdicht verbunden.

Die Trennschicht 1380 kann ein einstückiges Folienelement umfassen. Speziell kann ein schlauchförmiges Folienelement um den Aktor 1330 angeordnet werden und die geöffneten Seiten oder die geöffnete Seite des Folienelements (luftdicht) verschweißt werden, sodass der Aktor 1330, insbesondere vollständig, von dem Folienelement umgeben ist.

Die Trennschicht 1380 umfasst ein Ventil 1399. Über das Ventil 1399 kann ein Druck außerhalb der Trennschicht 1380 (die Trennschicht 1380 umgebend) und ein Druck zwischen der Trennschicht 1380 und dem Aktor 1330 angepasst werden. Beispielsweise können die Folienelemente 1381, 1382 oder eine einstückige Folie um den Aktor 1330 gelegt werden, sodass Luft zwischen dem Aktor 1330 und der Folie über das Ventil 1399 gesaugt oder gedrückt werden kann. Dadurch liegt die Folie eng an dem Aktor 1330 an und der Druck zwischen dem Aktor 1330 und der Trennschicht 1380 ist gegenüber der Umgebung reduziert. Die Folienelemente 1381, 1382 (oder eine einstückige Folie) können miteinander verschweißt werden, sodass der Unterdruck zwischen dem Aktor 1330 und der Trennschicht 1380 erhalten bleibt.

In Figur 13b sind Kavitäten 1335, 1335' in dem Aktor 1330 ausgebildet, je eine Kavität 1335, 1335' in einer der Kavitätsflächen des Aktors 1330. Die Trennschicht 1380 folgt der Einschnürung des Aktors 1330 zur Ausbildung einer Kavität 1335, 1335'.

Wird ein Fluid in einer Kavität 1335, 1335' transportiert (wie oben beschrieben) kontaktiert das Fluid nicht direkt den Aktor 1330, sondern die Trennschicht 1380. Dadurch können auch aggressive oder sensible Fluide in einer Transportvorrichtung 100, ... mit dem Aktor 1330 mit Trennschicht 1380 transportiert werden. Speziell wird eine Biokompatibilität einer solchen Transportvorrichtung 100, ... gewährleistet.

Die Dicke sB der Trennschicht 1380 kann geringer sein als die maximal in dem Aktor 1330 ausbildbare Tiefe sK der Kavität 13330.

Neben der mit Blick auf die Figuren 13a und 13b beschriebene Trennschicht 1380 kann die Trennschicht 1380 als Beschichtung, die festhaftend mit dem Aktor 1330 verbunden ist, ausgestaltet sein.

## Patentansprüche

1. **Transportvorrichtung** zum Transport eines Fluids, die Transportvorrichtung (100) mit:
(a) einem Gehäuse (110), wobei das Gehäuse einen Fluideinlass (111, 113) und einen Fluidauslass (113, 111) aufweist;
(b) einem Aktor (130, 1330), umfassend eine magnetische Formgedächtnislegierung, wobei der Aktor (130, 1330) zumindest abschnittsweise in dem Gehäuse (110) angeordnet ist;
(c) einem Antrieb (150), von dem der Aktor (130, 1330) so verformbar ist, dass in einer Kavitätsfläche (131) des Aktors (130, 1330) zumindest eine von dem Antrieb (150) bewegbare Kavität (135, 135', 1335, 1335') für das Fluid gebildet wird, um das Fluid in der Kavität (135, 135', 1335, 1335') von dem Fluideinlass (111, 113) zu dem Fluidauslass (113, 111) zu transportieren;
(d) wobei zumindest ein Abschnitt des Aktors (130, 1330) eine Trennschicht (1380) aufweist, durch die in dem Abschnitt des Aktors (130, 1330) ein direkter Kontakt zwischen dem Fluid und dem Aktor (130, 1330) verhindert ist,
(e) wobei die Vorrichtung ein Dichtelement (170) umfasst und das Dichtelement (170) eine elastische Eigenschaft aufweist, und wobei das Dichtelement (170) in einem Bereich der Kavitätsfläche (131), in dem keine Kavität gebildet ist, an der Kavitätsfläche (131) des Aktors (130, 1330) anliegt, und das Dichtelement (170) in einem Bereich der Kavitätsfläche (131) des Aktors (130, 1330), in dem die Kavität (135, 135', 1335, 1335') gebildet ist, anliegt, wenn die Kavität (135, 135', 1335, 1335') durch den Antrieb (150) in dem Aktor (130, 1330) gebildet ist.

2. Vorrichtung nach Anspruch 1, wobei das Gehäuse (110) eine Nut (117) aufweist in der zumindest ein Abschnitt des Dichtelements (170) angeordnet ist.

3. Vorrichtung nach einem der Ansprüche 1 oder 2, wobei der Aktor (430) von dem Antrieb (450) so verformbar ist, dass in dem Aktor (450) zwei von dem Antrieb (450) bewegbare Kavitäten (635, 635') für das Fluid gebildet werden, um das Fluid in den Kavitäten (635, 635') von dem Fluideinlass (411, 413) zu dem Fluidauslass (413, 411) zu transportieren und die Vorrichtung ein Dichtelement (470) umfasst, wobei das Dichtelement (470) zumindest eine Ausnehmung (471, 472, 473, 474) aufweist und wobei das Dichtelement (470) so in dem Gehäuse (410) angeordnet ist, dass die Kavitäten (635, 635') zumindest zeitweise während des Transports des Fluids von dem Fluideinlass (411, 413) zu dem Fluidauslass (413, 411) über die Ausnehmung (471, 472, 473, 474) fluidkommunizierend verbunden sind.

4. Vorrichtung nach Anspruch 3, wobei der Aktor (430) so verformbar ist, dass die Kavitäten (635, 635') auf gegenüberliegenden Seiten des Aktors (430) gebildet werden.

5. Vorrichtung nach Anspruch 3 oder 4, wobei das Dichtelement (470) zumindest zwei Ausnehmungen (471, 472, 473, 474) umfasst, die bevorzugt so in dem Dichtelement (470) ausgebildet sind, dass keine Fluidkommunikation während des Transports des Fluids von dem Fluideinlass (411, 413) zu dem Fluidauslass (413, 411) zwischen den Ausnehmungen (471, 472, 473, 474) möglich ist.

6. Vorrichtung nach einem der Ansprüche 3 bis 5, wobei das Dichtelement vier Ausnehmungen (471, 472, 473, 474) umfasst, wobei bevorzugt je zwei der Ausnehmungen (471, 472, 473, 474) zumindest zeitweise während des Transports des Fluids von dem Fluideinlass (411, 413) zu dem Fluidauslass (413, 411) fluidkommunizierend verbunden sind.

7. Vorrichtung nach einem der Ansprüche 3 bis 6, wobei das Dichtelement (470) zumindest zwei Flächen unterschiedlicher Seiten des Aktors (430) zumindest abschnittsweise kontaktiert.

8. Vorrichtung nach einem der Ansprüche 3 bis 7, mit einer ersten Dichtbahn (578) und einer zweiten Dichtbahn (579), wobei die erste Dichtbahn (578) eine Seite des Aktors (430, ...) kontaktiert und die zweite Dichtbahn (579) eine andere Seite des Aktors (430, ...) kontaktiert, insbesondere die kontaktierten Seiten des Aktors (430) gegenüberliegende Seiten sind.

9. Vorrichtung nach einem der Ansprüche 1 bis 8, wobei das Gehäuse (130) zumindest einen Diffusor (112, 114) umfasst, insbesondere zwei Diffusoren (112, 114) umfasst.

10. Vorrichtung nach Anspruch 9, wobei ein Diffusor (112) mit dem Fluideinlass (111) verbunden ist und ein Diffusor (114) mit dem Fluidauslass (113) verbunden ist und wobei jeweils eine dem Aktor (130) näherliegende Seite jedes Diffusors (112, 114) eine größere Querschnittsfläche aufweist als eine dem Aktor (130) fernerliegende Seite jedes Diffusors (112, 114).

11. Vorrichtung nach einem der Ansprüche 1 bis 10, wobei das Dichtelement (170) ein Elastomer umfasst, insbesondere ein thermoplastisches Elastomer, und/oder einen Schaumstoff umfasst, insbesondere einen geschlossenzelligen Schaumstoff.

12. Vorrichtung nach einem der Ansprüche 1 bis 11, wobei das Gehäuse (110) ein Metall oder einen Kunststoff, insbesondere Elastomer, oder ein Gradienten-Material umfasst.

13. Vorrichtung nach einem der Ansprüche 1 bis 12, wobei das Gehäuse (110) zumindest abschnittsweise eine PTFE-Beschichtung aufweist, insbesondere zumindest die Fläche des Gehäuses (110), die die Kavität (135) begrenzt.

14. Vorrichtung nach einem der Ansprüche 1 bis 13, wobei zumindest zwei, bevorzugt mehrere, Kavitäten (135) gleichzeitig in derselben Fläche des Aktors (130) bildbar sind.

15. Vorrichtung nach einem der Ansprüche 1 bis 14, mit einem Temperatursensor (1290), um eine Temperatur des Aktors (130) zu erfassen; oder
mit einem optischen Sensor (1291), durch den das Vorhandensein einer Kavität (135) in dem Aktor (130) erfassbar ist; oder
mit einem Drucksensor (1292), durch den ein Druck am Fluideinlass (111) oder am Fluidauslass (113) erfassbar ist; insbesondere einem Differenzdrucksensor, durch den eine Druckdifferenz zwischen dem Fluideinlass (111) und dem Fluidauslass (113) erfassbar ist; oder
mit einem Piezosensor (1293), bevorzugt mit zwei Piezosensoren, um eine Aktuierung des Aktors (130) zu erfassen; oder
mit einem Dehnmesstreifen (1295), bevorzugt mit zwei Dehnmessstreifen, um eine Aktuierung des Aktors (130) zu erfassen.

## Claims

1. A transport device for transporting a fluid, the transport device (100) comprising:
(a) a housing (110), wherein the housing has a fluid inlet (111, 113) and a fluid outlet (113, 111);
(b) an actuator (130, 1330) comprising a magnetic shape-memory alloy, wherein the actuator (130, 1330) is arranged at least in sections in the housing (110);
(c) a drive (150) by which the actuator (130, 1330) is deformable in such a way that at least one cavity (135, 135', 1335, 1335') for the fluid is formed in the actuator (130, 1330), wherein the cavity is movable by the drive (150) in order to transport the fluid in the cavity (135, 135', 1335, 1335') from the fluid inlet (111, 113) to the fluid outlet (113, 111);
(d) wherein at least one section of the actuator (130, 1330) has a separation layer (1380) by which a direct contact between the fluid and the actuator (130, 1330) is prevented in said section of the actuator (130, 1330);
(e) wherein the device comprises a sealing element (170) and the sealing element (170) is designed and arranged between the actuator (130, 1330) and the housing (110) in such a way that the cavity (135, 135', 1335, 1335') is edge-sealed or end-sealed during the transport of the fluid from the fluid inlet (111, 113) to the fluid outlet (113, 111),
(f) wherein the sealing element (170) has an elastic property, and wherein the sealing element (170) abuts against the cavity surface (131) of the actuator (130, 1330) in a section of the cavity surface (131) in which no cavity is formed, and the sealing element (170) abuts against a section of the cavity surface (130) of the actuator (130, 1330) in which the cavity (135, 135', 1335, 1335') is formed when the cavity (135, 135', 1335, 1335') is formed in the actuator (130, 1330) by the drive (150).

2. The device according to claim 1, wherein the housing (110) has a groove (117) in which at least one section of the sealing element (170) is arranged.

3. The device according to any one of claims 1 or 2, wherein the actuator (430) is deformable by the drive (450) in such a way that two cavities (635, 635') for the fluid are formed in the actuator (450), wherein the cavities are movable by the drive (450) in order to transport the fluid in the cavities (635, 635') from the fluid inlet (411, 413) to the fluid outlet (413, 411), and wherein the device comprises a sealing element (470), wherein the sealing element (470) has at least one recess (471, 472, 473, 474), and wherein the sealing element (470) is arranged in the housing (410) in such a way that the cavities (635, 635') are at least temporarily in fluid communication via the recess (471, 472, 473, 474) during the transport of the fluid from the fluid inlet (411, 413) to the fluid outlet (413, 411).

4. The device according to claim 3, wherein the actuator (430) is deformable in such a way that the cavities (635, 635') are formed on opposite sides of the actuator (430).

5. The device according to claims 3 or 4, wherein the sealing element (470) comprises at least two recesses (471, 472, 473, 474), which are preferably designed in the sealing element (470) in such a way that no fluid communication is possible between the recesses (471, 472, 473, 474) during the transport of the fluid from the fluid inlet (411, 413) to the fluid outlet (413, 411).

6. The device according to any one of claims 3 to 5, wherein the sealing element comprises four recesses (471, 472, 473, 474), wherein preferably two, respectively, of the recesses (471, 472, 473, 474) are at least temporarily in fluid communication during the transport of the fluid from the fluid inlet (411, 413) to the fluid outlet (413, 411).

7. The device according to any one of claims 3 to 6, wherein the sealing element (470) contacts, at least in sections, at least two faces of different sides of the actuator (430).

8. The device according to any one of claims 3 to 7, comprising a first sealing membrane (578) and a second sealing membrane (579), wherein the first sealing membrane (578) contacts a side of the actuator (430, ...) and the second sealing membrane (579) contacts a different side of the actuator (430, ...), wherein preferably the contacted sides of the actuator (430, ...) are opposite sides.

9. The device according to any one of claims 1 to 8, wherein the housing (130) comprises at least one diffusor (112, 114), preferably two diffusors (112, 114).

10. The device according to claim 9, wherein a diffusor (112) is connected to the fluid inlet (111) and a diffusor (114) is connected to the fluid outlet (113), and wherein, respectively, a side of each diffusor (112, 114) that is closer to the actuator (130) has a larger cross-sectional area than a side of each diffusor (112, 114) that is more remote from the actuator (130).

11. The device according to any one of claims 1 to 10, wherein the sealing element (170) comprises an elastomer, preferably a thermoplastic elastomer, and/or a foam material, preferably a closed-cell foam material.

12. The device according to any one of claims 1 to 11, wherein the housing (110) comprises a metal or a plastic material, preferably an elastomer or a gradient material.

13. The device according to any one of claims 1 to 12, wherein the housing (110) has, at least in sections, a PTFE coating, preferably at least the face of the housing (110) which delimits the cavity (135).

14. The device according to any one of claims 1 to 13, wherein at least two, preferably a plurality of cavities (135, 135'), are deformable simultaneously in the same face of the actuator (130).

15. The device according to any one of claims 1 to 14, comprising a temperature sensor (1290) by which a temperature of the actuator (130) is detectable; or
comprising an optical sensor (1291) by which the presence of a cavity (135) in the actuator (130) is detectable; or
comprising a pressure sensor (1292) by which a pressure at the fluid inlet (111) or at the fluid outlet (113) is detectable; especially a differential pressure sensor by which a pressure differential between the fluid inlet (111) and fluid outlet (113) is detectable; or
comprising a piezo sensor (1293), preferably comprising two piezo sensors in order to detect an actuation of the actuator (130); or
comprising a strain gauge (1295), preferably comprising two strain gauges in order to detect an actuation of the actuator (130).

## Revendications

1. Dispositif de transport destiné à transporter un fluide, le dispositif de transport (100) comportant :
(a) un boîtier (110), dans lequel le boîtier comporte une entrée de fluide (111, 113) et une sortie de fluide (113, 111) ;
(b) un actionneur (130, 1330) comprenant un alliage magnétique à mémoire de forme, dans lequel l'actionneur (130, 1330) est agencé au moins dans certaines zones dans le boîtier (110) ;
(c) un entraînement (150) qui peut déformer l'actionneur (130, 1330), de telle sorte qu'au moins une cavité (135, 135', 1335, 1335') pouvant être déplacée par l'entraînement (135) est formée pour le fluide dans une face de cavité (131) de l'actionneur (130, 1330) afin de transporter le fluide dans la cavité (135, 135', 1335, 1335') depuis l'entrée de fluide (111, 113) jusqu'à la sortie de fluide (113, 111) ;
(d) dans lequel au moins une partie de l'actionneur (130, 1330) comporte une couche de séparation (1380) qui empêche un contact direct entre le fluide et l'actionneur (130, 1330) dans la partie de l'actionneur (130, 1330),
(e) dans lequel le dispositif comprend un élément d'étanchéité (170) et l'élément d'étanchéité (170) est conçu et agencé entre l'actionneur (130, 1330) et le boîtier (110) de telle sorte que la cavité (135, 135', 1335, 1335') est rendue étanche côté bord ou côté extrémité pendant le transport du fluide depuis l'entrée de fluide (111, 113) jusqu'à la sortie de fluide (113, 111),
(f) dans lequel l'élément d'étanchéité (170) a une propriété élastique et dans lequel l'élément d'étanchéité (170) est en butée contre la face de cavité (131) de l'actionneur (130, 1330) dans une zone de la face de cavité (131) dans laquelle aucune cavité n'est formée, et l'élément d'étanchéité (170) est en butée dans une zone de la face de cavité (131) de l'actionneur (130, 1330) dans laquelle la cavité (135, 135', 1335, 1335') est formée, lorsque la cavité (135, 135', 1335, 1335') est formée dans l'actionneur (130, 1330) par l'entraînement (150).

2. Dispositif selon la revendication 1, dans lequel le boîtier (110) comporte une rainure (117) dans laquelle est agencée au moins une partie de l'élément d'étanchéité (170).

3. Dispositif selon l'une des revendications 1 ou 2, dans lequel l'actionneur (430) peut être déformé par l'entraînement (450) de telle sorte que deux cavités (635, 635') pouvant être déplacées par l'entraînement (450) sont formées pour le fluide dans l'actionneur (450) afin de transporter le fluide dans les cavités (450, 635') depuis l'entrée de fluide (411, 413) jusqu'à la sortie de fluide (413, 411), et le dispositif comprend un élément d'étanchéité (470), dans lequel l'élément d'étanchéité (470) comporte au moins un évidement (471, 472, 473, 474) et dans lequel l'élément d'étanchéité (470) est agencé dans le boîtier (410) de telle sorte que les cavités (635, 635') sont au moins temporairement en communication fluidique par l'intermédiaire de l'évidement (471, 472, 473, 474) pendant le transport du fluide depuis l'entrée de fluide (411, 413) jusqu'à la sortie de fluide (413, 411).

4. Dispositif selon la revendication 3, dans lequel l'actionneur (430) est déformable de telle sorte que les cavités (635, 635') sont formées sur des côtés opposés de l'actionneur (430).

5. Dispositif selon la revendication 3 ou 4, dans lequel l'élément d'étanchéité (470) comprend au moins deux évidements (471, 472, 473, 474) qui sont de préférence formés dans l'élément d'étanchéité (470), de telle sorte qu'aucune communication fluidique n'est possible entre les évidements (471, 472, 473, 474) pendant le transport du fluide depuis l'entrée de fluide (411, 413) jusqu'à la sortie de fluide (413, 411).

6. Dispositif selon l'une des revendications 3 à 5, dans lequel l'élément d'étanchéité comprend quatre évidements (471, 472, 473, 474), dans lequel deux des évidements (471, 472, 473, 474) sont de préférence au moins temporairement en communication fluidique pendant le transport du fluide depuis l'entrée de fluide (411, 413) jusqu'à la sortie de fluide (413, 411).

7. Dispositif selon l'une des revendications 3 à 6, dans lequel l'élément d'étanchéité (470) est en contact au moins dans certaines zones avec au moins deux faces de différents côtés de l'actionneur (430).

8. Dispositif selon l'une des revendications 3 à 7, comportant une première membrane d'étanchéité (578) et une seconde membrane d'étanchéité (579), dans lequel la première membrane d'étanchéité (578) est en contact avec un côté de l'actionneur (430, ...) et la seconde membrane d'étanchéité (579) est en contact avec un autre côté de l'actionneur (430, ...), les côtés en contact de l'actionneur (430) étant en particulier des côtés opposés.

9. Dispositif selon l'une des revendications 1 à 8, dans lequel le boîtier (130) comprend au moins un diffuseur (112, 114), en particulier deux diffuseurs (112, 114).

10. Dispositif selon la revendication 9, dans lequel un diffuseur (112) est relié à l'entrée de fluide (111) et un diffuseur (114) est relié à la sortie de fluide (113) et dans lequel un côté de chaque diffuseur (112, 114) qui est plus près de l'actionneur (130) a respectivement une aire de section transversale plus grande qu'un côté de chaque diffuseur (112, 114) qui est plus éloigné de l'actionneur (130).

11. Dispositif selon l'une des revendications 1 à 10, dans lequel l'élément d'étanchéité (170) comprend un élastomère, en particulier un élastomère thermoplastique, et/ou une mousse, en particulier une mousse à alvéoles fermées.

12. Dispositif selon l'une des revendications 1 à 11, dans lequel le boîtier (110) comprend un métal ou une matière plastique, en particulier un élastomère, ou un matériau à gradient.

13. Dispositif selon l'une des revendications 1 à 12, dans lequel le boîtier (110) comporte un revêtement PTFE au moins dans certaines zones, en particulier au moins la face du boîtier (110) qui délimite la cavité (135).

14. Dispositif selon l'une des revendications 1 à 13, dans lequel au moins deux, de préférence plusieurs, cavités (135) peuvent être simultanément formées dans la même face de l'actionneur (130).

15. Dispositif selon l'une des revendications 1 à 14, comportant un capteur de température (1290) pour détecter une température de l'actionneur (130) ; ou
un capteur optique (1291) permettant de détecter la présence d'une cavité (135) dans l'actionneur (130) ; ou
un capteur de pression (1292) permettant de détecter une pression à l'entrée de fluide (111) ou à la sortie de fluide (113) , en particulier un capteur de pression différentielle permettant de détecter une différence de pression entre l'entrée de fluide (111) et la sortie de fluide (113) ; ou
un capteur piézoélectrique (1293), de préférence deux capteurs piézoélectriques, pour détecter un actionnement de l'actionneur (130) ; ou
un extensomètre (1295), de préférence deux extensomètres, pour détecter un actionnement de l'actionneur (130).
